# EUROPEAN PATENT APPLICATION

(11) **EP 3 790 039 A1**
(43) Date of publication of application: **10.03.2021**
(21) Application number: 19793639.6
(22) Date of filing: 24.04.2019
(51) Int. Cl.: H01L 21/60, B32B 27/34, C08F 2/44, C08F 22/06, H01L 23/29, H01L 23/31

(54) **RESIN COMPOSITION, LAMINATE, SEMICONDUCTOR WAFER WITH RESIN COMPOSITION LAYER, SUBSTRATE FOR MOUNTING SEMICONDUCTOR WITH RESIN COMPOSITION LAYER, AND SEMICONDUCTOR DEVICE**

(30) Priority: 26.04.2018 JP 2018085680
(71) Applicant: MITSUBISHI GAS CHEMICAL COMPANY, INC., Chiyoda-ku Tokyo 100-8324 (JP)
(72) Inventor: HIGASHIGUCHI, Kohei, Tokyo 125-8601 (JP); TAKIGUCHI, Takenori, Tokyo 125-8601 (JP); OKANIWA, Masashi, Tokyo 125-8601 (JP); KIDA, Tsuyoshi, Tokyo 125-8601 (JP)
(74) Representative: Hoffmann Eitle
(86) International application number: PCT/JP2019/017329
(87) International publication number: WO 2019/208604

(57) **Abstract**

A resin composition that has excellent adhesiveness to chips and substrates such as printed wiring boards and excellent flux activity is provided. The present invention provides a resin composition containing: a benzoxazine compound (A); an organic compound (B) having a flux function; and at least one thermosetting component (C) selected from a phenolic resin and a radical polymerizable thermosetting resin, wherein the radical polymerizable thermosetting resin is a resin or a compound having at least one or more functional groups selected from the group consisting of an alkenyl group, a maleimide group and a (meth)acryloyl group, and wherein a mass ratio between the benzoxazine compound (A) and the thermosetting component (C) ((A)/(C)) is 20/80 to 90/10.

## Description

### Technical Field

The present invention relates to a resin composition, a laminate using the resin composition, a semiconductor wafer with a resin composition layer, a substrate for mounting a semiconductor with a resin composition layer, and a semiconductor device. In more detail, the present invention relates to a resin composition that is useful as an underfill material.

### Background Art

In recent years, in association with the downsizing and performance improvement of semiconductor devices, flip chip bonding is getting a lot of attention as a method for mounting a semiconductor chip (hereinafter, may be abbreviated as "chip") on a substrate for mounting a semiconductor (hereinafter, may be abbreviated as the "substrate"). In the flip chip bonding, a construction method is common in which, after joining the chip and the substrate, the gap between the chip and the substrate is filled with an underfill material, which is then cured. However, due to the downsizing and performance improvement of semiconductor devices, the electrode pitch arranged on the chip has become narrower and the gap between the electrodes has also become narrower. As a result, there have been problems that operability is worsened due to a longer time for filling the underfill material, and that filling failures occur, such as unfilling. In response to this, a construction method has been examined in which, after supplying a pre-applied underfill material to the chip or the substrate, the joint of the chip and the substrate and the filling of the underfill material are carried out at the same time.

Since the underfill material is a member that comes into direct contact with the chip and the substrate, one of the important characteristics required for the underfill material is the adhesiveness to the chip and the substrate (hereinafter, may be abbreviated as "chip adhesiveness") that can withstand long term use in an environment where the semiconductor device is used.

Patent Document 1 describes a pre-applied underfill material that uses a radical polymerizable monomer as the main resin. In this Patent Document 1, there is a description that a silane coupling agent is compounded for the purpose of improving the adhesiveness to the chip.

Patent Document 2 describes an underfill material containing an epoxy resin, an imidazole compound, and a maleimide compound.

Patent Document 3 describes a pre-applied underfill material using an epoxy compound and a carboxyl group containing flux component, and mentions adhesion.

Patent Document 4 describes a resin composition containing a maleimide compound, an epoxy resin, and an epoxy resin curing agent as essential components, and describes that high adhesiveness was obtained in the resin composition after thermosetting.

Patent Document 5 describes a resin composition for printed wiring substrates, the resin composition being a thermosetting resin composition used for forming an insulating layer in a printed wiring substrate, and containing a maleimide compound having a specific structure, a benzoxazine compound, and an inorganic filler (C).

Patent Document 6 describes an adhesive for electronic components, containing an aliphatic epoxy compound and a benzoxazine compound as the curing base compounds, and also containing a phenolic curing agent.

Patent Document 7 describes an adhesive composition containing a thermosetting compound, a polymer having a functional group that is capable of reacting with the thermosetting compound, and a hardener, wherein the adhesive composition has a melt viscosity at a bonding temperature of 10 Pa·s or more and 15000 Pa·s or less, a gelling time at a bonding temperature of 10 seconds or longer, and a gelling time at 240°C of 1 second or longer and 10 seconds or shorter.

Patent Document 8 describes a method for producing a semiconductor device using a sheet-shaped thermosetting resin composition.

In addition, when the joint between a chip and a substrate is carried out via a metal that is easily oxidized, such as solder or copper, a flux component derived from a carboxylic acid or the like may be added to a pre-applied underfill material for the purpose of removing an oxidized layer, which is an inhibiting factor for joint, and obtaining good metal joint.

### Citation List

### Patent Document

Patent Document 1: Japanese Translation of PCT International Application Publication No. 2015-503220
Patent Document 2: Japanese Translation of PCT International Application Publication No. 2014-521754
Patent Document 3: Japanese Patent Application Laid-Open No. 2013-112730
Patent Document 4: Japanese Patent Application Laid-Open No. 2003-221443
Patent Document 5: Japanese Patent Application Laid-Open No. 2016-196548
Patent Document 6: Japanese Patent Application Laid-Open No. 2013-008800
Patent Document 7: Japanese Patent Application Laid-Open No. 2011-157529
Patent Document 8: Japanese Patent Application Laid-Open No. 2006-245242

### Summary of Invention

### Technical Problem

However, radical polymerizable monomers generally cures quickly, and the mobility of the adhesion site of the compounded silane coupling agent is rate-controlled by the main resin that has been polymerized before forming a sufficient number of bonds with the silanol groups on the surface of the chip. As a result, in the pre-applied underfill material described in Patent Document 1, sufficient adhesiveness to a chip and substrates such as printed wiring boards cannot be obtained. In addition, since radical polymerizable monomers cures quickly, the resin composition cures before it is embedded in the unevenness present on the surface of the chip. Therefore, there is a problem that sufficient anchor effect, which is useful in improving adhesiveness, cannot be obtained by the pre-applied underfill material described in Patent Document 1.

Since the material described in Patent Document 2 acts only on the polyimide passivation film, there is a problem that the application range is narrow.

In the technique described in Patent Document 3, reaction between the carboxyl group containing compound and the epoxy compound progresses slightly even at room temperature, and the flux activity is reduced over time during storage. Therefore, the pre-applied underfill material described in Patent Document 3 has problems such as unstable joint formation and poor mass productivity.

In the technique described in Patent Document 4, the water absorption rate of the maleimide resin is high, and thus proposing a problem that the chip adhesiveness after the moisture absorption treatment is significantly lowered. When the adhesiveness is insufficient, water penetrates from the peeling interface and the insulation reliability is greatly reduced. Note that it is difficult even for the maleimide resin alone to achieve both adhesiveness with the chips and adhesiveness with the printed wiring substrates.

In Patent Document 5, there is no description about the flux activity, and no description about the flux component, either. Therefore, the resin composition described in Patent Document 5 has a problem that good metal joint cannot be obtained.

In Patent Document 6, although the adhesiveness of the epoxy compound is high, the epoxy compound also reacts with the flux component, thus proposing a problem that flux activity sufficient for obtaining good metal joint cannot be obtained.

The adhesive composition of Patent Document 7 contains a hardener having a flux property, but in Examples, an epoxy compound and a polymer containing an epoxy group are used, and both react at a temperature lower than the bonding temperature. Therefore, it is difficult to obtain sufficient flux activity.

Patent Document 8 also describes that an epoxy resin is suitable as the thermosetting resin contained in the thermosetting resin composition, but as described above, the epoxy compound also reacts with the flux component, thus proposing a problem that flux activity sufficient for obtaining good metal joint cannot be obtained.

The present invention has been made in view of such problems, and an object of the present invention is to provide a resin composition that has excellent adhesiveness to a chip and substrates and excellent flux activity and that is suitable for an underfill material, a laminate, a semiconductor wafer with a resin composition layer, a substrate for mounting a semiconductor with a resin composition layer, and a semiconductor device. Preferably, an object of the present invention is to provide a resin composition that has excellent adhesiveness to a chip and excellent adhesiveness to substrates such as printed wiring boards, and has excellent flux activity, and that is suitable for an underfill material, a laminate, a semiconductor wafer with a resin composition layer, a substrate for mounting a semiconductor with a resin composition layer, and a semiconductor device.

### Solution to Problem

The present inventors have, as a result of devoted examinations to solve the above problems, found out that a resin composition suitable for an underfill material, comprising: a benzoxazine compound (A); an organic compound (B) having a flux function; and at least one thermosetting component (C) selected from a phenolic resin and a radical polymerizable thermosetting resin, wherein the mass ratio between the benzoxazine compound (A) and the thermosetting component (C) falls within a particular range can solve the above problems, and reached the present invention.

More specifically, the present invention includes the following contents.
[1] A resin composition comprising: a benzoxazine compound (A); an organic compound (B) having a flux function; and at least one thermosetting component (C) selected from a phenolic resin and a radical polymerizable thermosetting resin, wherein the radical polymerizable thermosetting resin is a resin or a compound having at least one or more functional groups selected from the group consisting of an alkenyl group, a maleimide group and a (meth)acryloyl group, and wherein a mass ratio between the benzoxazine compound (A) and the thermosetting component (C) ((A)/(C)) is 20/80 to 90/10.
[2] The resin composition according to [1], wherein the benzoxazine compound (A) has a molecular weight of 400 or more.
[3] The resin composition according to [1] or [2], wherein the benzoxazine compound (A) comprises at least one selected from the group consisting of compounds represented by the following formula (1), the following formula (2), the following formula (3), and the following formula (4). 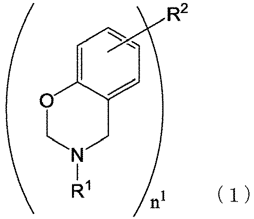
   (In the formula (1), each R¹ independently represents an aryl group, an aralkyl group, an alkenyl group, an alkyl group, or a cycloalkyl group; each R² independently represents a hydrogen atom, an aryl group, an aralkyl group, an alkenyl group, an alkyl group, a cycloalkyl group, or a monovalent to tetravalent organic group represented by the following general formulas (a) to (t); and n¹ represents an integer of 1 to 4.) 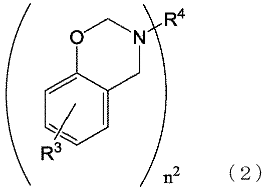
   (In the formula (2), each R³ independently represents a hydrogen atom, an aryl group, an aralkyl group, an alkenyl group, an alkyl group, or a cycloalkyl group; each R⁴ independently represents an aryl group, an aralkyl group, an alkenyl group, an alkyl group, a cycloalkyl group, or a monovalent to tetravalent organic group represented by the following general formulas (a) to (o); and n² represents an integer of 1 to 4.) 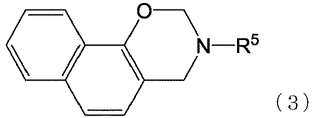
   (In the formula (3), each R⁵ independently represents an alkyl group, a cycloalkyl group, or a phenyl group optionally having a substituent.) 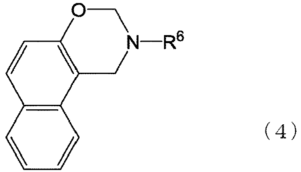
   (In the formula (4), each R⁶ independently represents an alkyl group, a cycloalkyl group, or a phenyl group optionally having a substituent.) 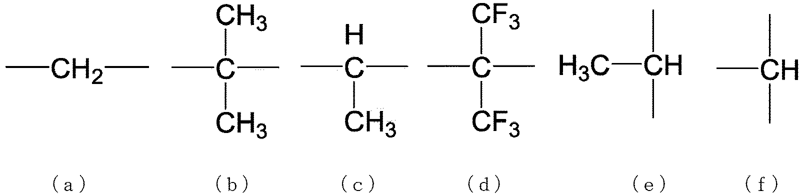 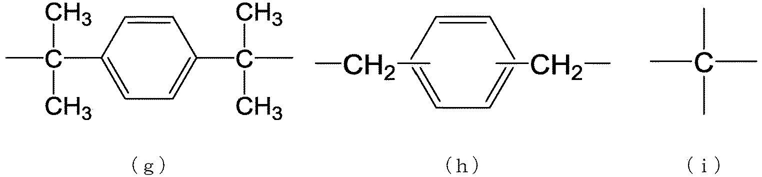 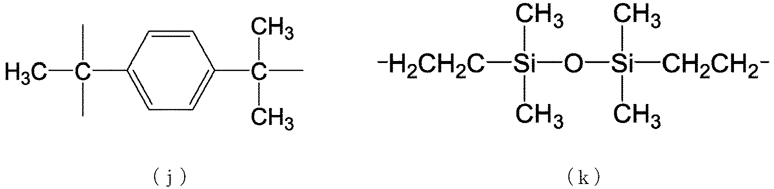 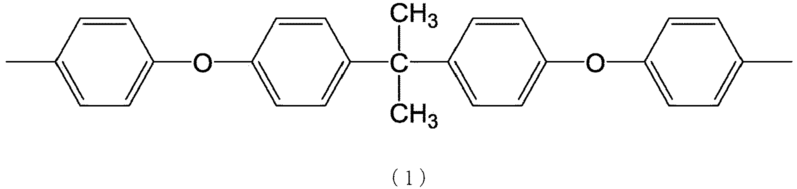 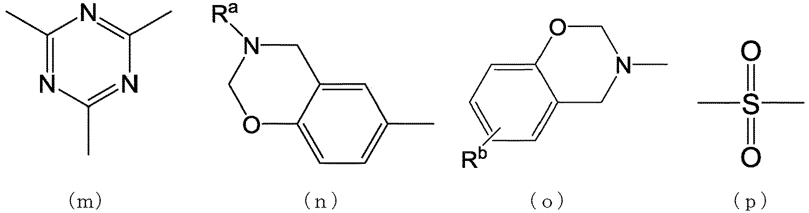 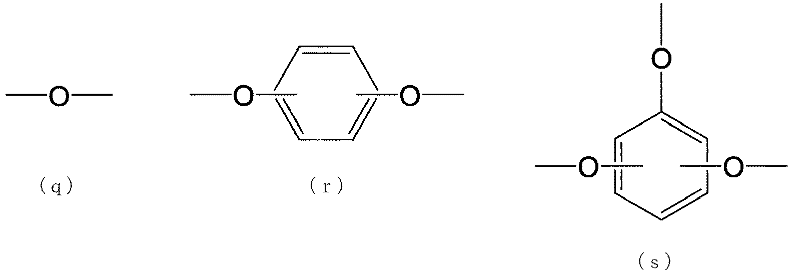 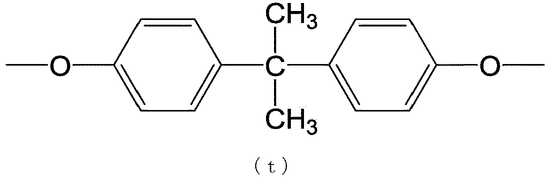
   (In the formulas (a) to (t), each R^{a} independently represents an aryl group, an aralkyl group, an alkenyl group, an alkyl group, or a cycloalkyl group; each R^{b} independently represents a hydrogen atom, an aryl group, an aralkyl group, an alkenyl group, an alkyl group, or a cycloalkyl group.)
[4] The resin composition according to any of [1] to [3], wherein the benzoxazine compound (A) comprises at least one selected from the group consisting of compounds represented by the following formula (5) and the following formula (6). 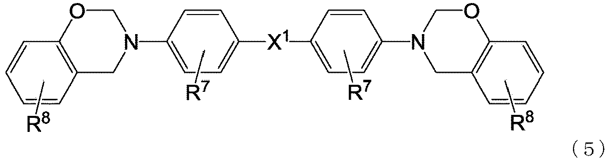
   (In the formula (5), each R⁷ independently represents a hydrogen atom, an aryl group, an aralkyl group, an alkenyl group, an alkyl group, or a cycloalkyl group; each R⁸ independently represents a hydrogen atom, an aryl group, an aralkyl group, an alkenyl group, an alkyl group, or a cycloalkyl group; and X¹ represents an alkylene group, a group represented by the following formula (7), a group represented by the formula "-SO₂-", a group represented by the formula "-CO-", an oxygen atom, or a single bond.) 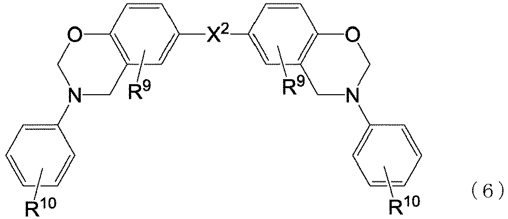
   (In the formula (6), each R⁹ independently represents a hydrogen atom, an aryl group, an aralkyl group, an alkenyl group, an alkyl group, or a cycloalkyl group; each R¹⁰ independently represents a hydrogen atom, an aryl group, an aralkyl group, an alkenyl group, an alkyl group, or a cycloalkyl group; and X² represents an alkylene group, a group represented by the following formula (7), a group represented by the formula "-SO₂-", a group represented by the formula "-CO-", an oxygen atom, or a single bond.) 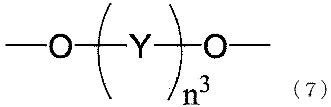
   (In the formula (7), Y is an alkylene group or a hydrocarbon group having 6 or more and 30 or less carbon atoms and having an aromatic ring; and n³ represents an integer of 0 or more and 5 or less.)
[5] The resin composition according to any of [1] to [4], wherein the benzoxazine compound (A) comprises at least one selected from the group consisting of a compound represented by the following formula (5-1), a compound represented by the following formula (5-2), a compound represented by the following formula (5-3), a compound represented by the following formula (6-1), a compound represented by the following formula (6-2), and a compound represented by the following formula (6-3). 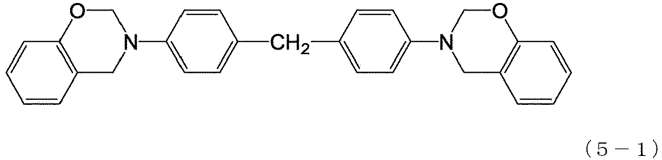 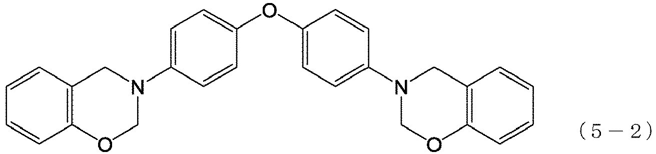 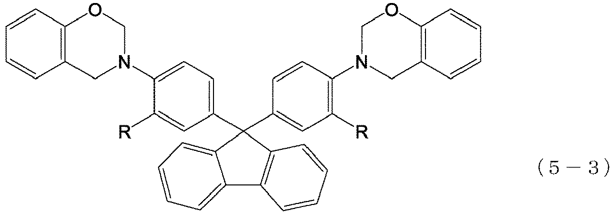
   (In the formula (5-3), each R independently represents a hydrogen atom or a hydrocarbon group having 1 to 4 carbon atoms.) 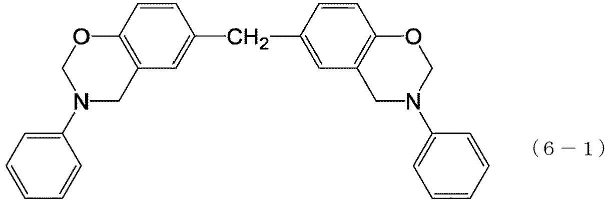 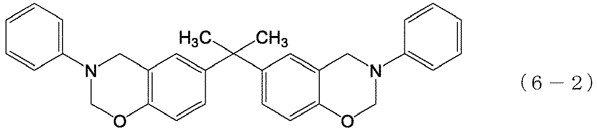 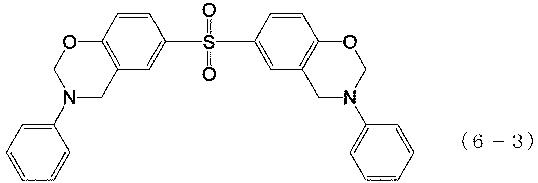
[6] The resin composition according to any of [1] to [5], wherein the organic compound (B) having the flux function has an acid dissociation constant pKa of 3.8 or more and 15.0 or less.
[7] The resin composition according to any of [1] to [6], wherein the organic compound (B) having the flux function has a molecular weight of 200 or more and 8,000 or less.
[8] The resin composition according to any of [1] to [7], wherein the organic compound (B) having the flux function comprises at least one selected from the group consisting of abietic acid, neoabietic acid, dehydroabietic acid, pimaric acid, isopimaric acid, palustric acid, diphenolic acid, dihydroabietic acid, tetrahydroabietic acid, an acid-modified rosin resin, N,N'-bis(salicylidene)-1,2-propanediamine, N,N'-bis(salicylidene)-1,3-propanediamine, and phenolphthalin.
[9] The resin composition according to any of [1] to [8], wherein the thermosetting component (C) is a maleimide compound.
[10] The resin composition according to any of [1] to [9], wherein the thermosetting component (C) comprises at least one selected from the group consisting of 2,2-bis(4-(4-maleimidophenoxy)phenyl)propane, a maleimide compound represented by the following formula (8), a maleimide compound represented by the following formula (9), a maleimide compound represented by the following formula (10), a maleimide compound represented by the following formula (11), a compound represented by the following formula (12), and a compound represented by the following formula (13). 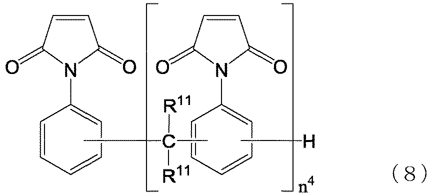
   (In the formula (8), each R¹¹ independently represents a hydrogen atom or a methyl group; and n⁴ represents an integer of 1 or more and 10 or less.) 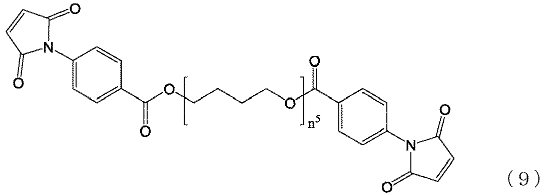
   (In the formula (9), n⁵ represents an integer of 1 or more and 30 or less.) 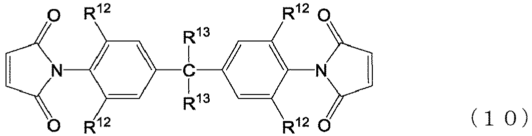
   (In the formula (10), each R¹² independently represents a hydrogen atom, a methyl group, or an ethyl group; and each R¹³ independently represents a hydrogen atom or a methyl group.) 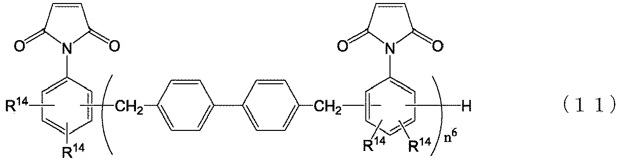
   (In the formula (11), each R¹⁴ independently represents a hydrogen atom, an alkyl group having 1 to 5 carbon atoms, or a phenyl group; and n⁶ represents an integer of 1 or more and 10 or less.) 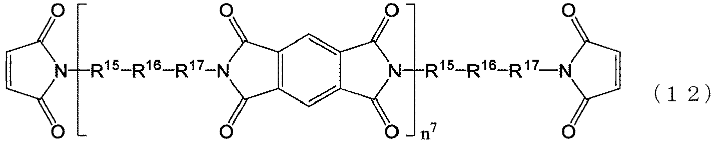
   (In the formula (12), R¹⁵ and R¹⁷ each independently represent a hydrocarbon group in which 8 or more atoms are linearly linked; each R¹⁶ independently represents a substituted or unsubstituted cyclic hydrocarbon group optionally having a heteroatom in which 4 or more and 10 or less atoms constitute the ring; and n⁷ represents a number of 1 or more and 10 or less.) 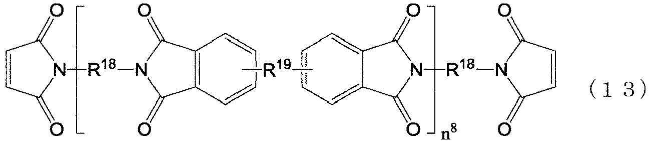
   (In the formula (13), each R¹⁸ independently represents an alkylene group; each R¹⁹ independently represents an alkylene group, a group represented by the following formula (7), a group represented by the formula "-SO₂-", a group represented by the formula "-CO-", a group represented by the following formula (14), an oxygen atom, or a single bond; and n⁸ represents a number of 1 or more and 10 or less.) 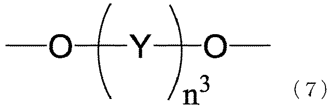
   (In the formula (7), Y is an alkylene group or a hydrocarbon group having 6 or more and 30 or less carbon atoms and having an aromatic ring, and n³ represents an integer of 0 or more and 5 or less.) 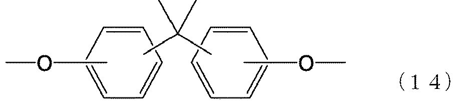
[11] The resin composition according to any of [1] to [10], wherein a content of the organic compound (B) having the flux function in the resin composition is 1 part by mass or more and 50 parts by mass or less based on 100 parts by mass in total of the benzoxazine compound (A) and the thermosetting component (C).
[12] The resin composition according to any of [1] to [11], further comprising a radical polymerization initiator (D).
[13] The resin composition according to [12], wherein the radical polymerization initiator (D) has a 10 hour half-life period temperature of 100°C or higher.
[14] The resin composition according to [12] or [13], wherein the radical polymerization initiator (D) is an organic peroxide.
[15] The resin composition according to any of [12] to [14], wherein the radical polymerization initiator (D) has a peroxy ester, a peroxy ketal, a dialkyl peroxide, or a hydroperoxide skeleton.
[16] The resin composition according to any of [12] to [15], wherein the radical polymerization initiator (D) comprises at least one selected from the group consisting of dicumyl peroxide, di(2-tert-butylperoxyisopropyl)benzene, 1,1,3,3-tetramethylbutyl hydroperoxide, 2,5-dimethyl-2,5-bis(tert-butylperoxy)hexyne-3, and tert-butyl hydroperoxide.
[17] The resin composition according to any of [12] to [16], wherein a content of the radical polymerization initiator (D) in the resin composition is 0.05 parts by mass or more and 10 parts by mass or less based on 100 parts by mass in total of the benzoxazine compound (A) and the thermosetting component (C).
[18] The resin composition according to any of [1] to [17], further comprising an inorganic filler (E).
[19] The resin composition according to [18], wherein the inorganic filler (E) has an average particle diameter of 3 µm or less.
[20] The resin composition according to [18] or [19], wherein the inorganic filler (E) comprises at least one selected from the group consisting of silica, aluminum hydroxide, alumina, boehmite, boron nitride, aluminum nitride, magnesium oxide, and magnesium hydroxide.
[21] The resin composition according to any of [18] to [20], wherein the inorganic filler (E) is silica.
[22] The resin composition according to any of [18] to [21], wherein a content of the inorganic filler (E) in the resin composition is 500 parts by mass or less based on 100 parts by mass in total of the benzoxazine compound (A) and the thermosetting component (C).
[23] The resin composition according to any of [1] to [22], further comprising a flexibility imparting component (F).
[24] The resin composition according to [23], wherein the flexibility imparting component (F) comprises a thermoplastic polymer compound and the polymer compound has a mass average molecular weight of 1,000 or more and 1,000,000 or less.
[25] The resin composition according to [23] or [24], wherein the flexibility imparting component (F) is a (meth)acrylic oligomer and/or a (meth)acrylic polymer.
[26] The resin composition according to any of [23] to [25], wherein a content of the thermosetting component (C) in the resin composition is 10 parts by mass or more and 70 parts by mass or less based on 100 parts by mass in total of the benzoxazine compound (A), the thermosetting component (C), and the flexibility imparting component (F).
[27] The resin composition according to any of [23] to [26], wherein a content of the organic compound (B) having the flux function in the resin composition is 1 part by mass or more and 50 parts by mass or less based on 100 parts by mass in total of the benzoxazine compound (A), the thermosetting component (C), and the flexibility imparting component (F).
[28] The resin composition according to any of [23] to [27], wherein a content of the inorganic filler (E) in the resin composition is 500 parts by mass or less based on 100 parts by mass in total of the benzoxazine compound (A), the thermosetting component (C), and the flexibility imparting component (F).
[29] The resin composition according to any of [1] to [28], for use in a pre-applied underfill material.
[30] A laminate comprising: a supporting material; and a layer comprising the resin composition according to any of [1] to [29] laminated on the supporting material.
[31] A semiconductor wafer with a resin composition layer, comprising: a semiconductor wafer; and the laminate according to [30] laminated on the semiconductor wafer, wherein the layer comprising the resin composition is laminated on the semiconductor wafer.
[32] A substrate for mounting a semiconductor with a resin composition layer, comprising: a substrate for mounting a semiconductor; and the laminate according to [30] laminated on the substrate for mounting the semiconductor, wherein the layer comprising the resin composition is laminated on the substrate for mounting the semiconductor.
[33] A semiconductor device, comprising the semiconductor wafer with the resin composition layer according to [31]; and/or the substrate for mounting the semiconductor with the resin composition layer according to [32].

### Advantageous Effects of Invention

According to the present invention, a resin composition that has excellent adhesiveness to a chip and substrates such as printed wiring boards and excellent flux activity and that is suitable for the use for an underfill material, a laminate, a semiconductor wafer with a resin composition layer, a substrate for mounting a semiconductor with a resin composition layer, and a semiconductor device can be obtained.

### Description of Embodiments

An embodiment for carrying out the present invention (which will be simply referred to as the "present embodiment" hereinafter) will now be described. Note that the present embodiment below is given in order to illustrate the present invention, and the present invention is not limited only to the present embodiment.

According to one aspect of the present embodiment, a resin composition contains: a benzoxazine compound (A); an organic compound (B) having a flux function; and at least one thermosetting component (C) selected from a phenolic resin and a radical polymerizable thermosetting resin, and the radical polymerizable thermosetting resin is a resin or a compound having at least one or more functional groups selected from the group consisting of an alkenyl group, a maleimide group and a (meth)acryloyl group, and the mass ratio between the benzoxazine compound (A) and the thermosetting component (C) ((A)/(C)) is 20/80 to 90/10. From the viewpoint of achieving action effects according to the present invention more effectively and reliably, the above resin composition is preferably for an underfill material and is more preferably for a pre-applied underfill material.

Another aspect of the present embodiment is a resin composition containing, in addition to the above resin composition components, a radical polymerization initiator (D).

Another aspect of the present embodiment is a resin composition containing, in addition to the above resin composition components, an inorganic filler (E).

Another aspect of the present embodiment is a resin composition containing, in addition to the above resin composition components, a flexibility imparting component (F) .

In another aspect of the present embodiment, a laminate obtained by using the resin composition according to the present embodiment (hereinafter, also referred to as the "resin laminate"), a semiconductor wafer with a resin composition layer fabricated by using the laminate, a substrate for mounting a semiconductor with a resin composition layer fabricated by using the laminate, and a semiconductor device fabricated by using the resin composition of the present invention are also provided.

Note that, in the present embodiment, "(meth)acryloyl" refers to both "acryloyl" and "methacryloyl" corresponding thereto, "(meth)acryl" refers to both "acryl" and "methacryl" corresponding thereto, "(meth)acrylate" refers to both "acrylate" and "methacrylate" corresponding thereto, and "(meth)allyl" refers to both "allyl" and "methallyl" corresponding thereto.

### [I. Resin composition]

The resin composition of the present embodiment is suitably a resin composition that is used as an underfill material to be used for the flip chip bonding, and contains a benzoxazine compound (A), an organic compound (B) having a flux function, and at least one thermosetting component (C) selected from a phenolic resin and a radical polymerizable thermosetting resin.

The radical polymerizable thermosetting resin is a thermosetting resin having a functional group that is to be polymerized by radicals, and is a resin or a compound having at least one or more functional groups selected from the group consisting of an alkenyl group, a maleimide group and a (meth)acryloyl group.

In the resin composition of the present embodiment, the mass ratio between the benzoxazine compound (A) and the thermosetting component (C) ((A)/(C)) is 20/80 to 90/10, preferably 25/75 to 85/15, more preferably 25/75 to 80/20, and still more preferably 25/75 to 75/25 from the viewpoint of obtaining a resin composition that has excellent adhesiveness to a chip and substrates such as printed wiring boards and excellent flux activity and that is suitable for an underfill material. When the content ratio of the benzoxazine compound (A) is smaller than the lower limit of the above range, sufficient adhesiveness to a substrate cannot be obtained. In addition, when the content ratio thereof is larger than the upper limit, the reaction between the benzoxazine compound and the flux component emerges, and sufficient flux activity cannot be obtained.

The resin composition of the present embodiment may contain at least any one of a radical polymerization initiator (D), an inorganic filler (E), and a flexibility imparting component (F).

It is not clear why a resin composition that has excellent adhesiveness to a chip and substrates such as printed wiring boards and excellent flux activity and that is suitable for the use for an underfill material can be obtained in the present invention, but the present inventors presume the reason as follows. The benzoxazine compound creates a phenolic hydroxy group and a tertiary amino group as polar groups that contribute to the adhesiveness after the ring opening polymerization. As a result, it is presumed that the polar groups existing on the surface of the adherend and the chemical interaction such as hydrogen bond are effectively expressed, thereby providing strong adhesiveness. In addition, it is also presumed that the benzoxazine compound is less likely to react with the flux component during storage or due to heat treatment compared to epoxy compounds, thereby not causing deactivation of the flux.

### [I-1. Benzoxazine compound (A)]

The benzoxazine compound (A) in the resin composition of the present embodiment is not particularly limited as long as it has an oxazine ring as the basic skeleton. In the present embodiment, the benzoxazine compound (A) also includes compounds having a polycyclic oxazine skeleton, such as naphthoxazine compounds.

The benzoxazine compound (A) does not generate a volatile by-product by heating, and the benzoxazine ring undergoes the ring opening polymerization and is suitably cured. The cured product is excellent in heat resistance, water resistance, and flame retardancy. In addition, the benzoxazine compound (A) is expected to have high chip adhesiveness and substrate adhesiveness because a phenolic hydroxy group and a tertiary amino group, which are polar groups, are produced upon the ring opening polymerization.

The benzoxazine compound (A) may be used in combination with the thermosetting component (C) other than the benzoxazine compound (A) described below as long as the adhesiveness that the above benzoxazine compound (A) has is not impaired. As the thermosetting component (C), a compound that exhibits reactivity with the benzoxazine compound (A) and does not exhibit reactivity with a flux component is preferable.

For the benzoxazine compound (A), from the viewpoint of preventing voids caused by volatilization of the benzoxazine compound (A) during the flip chip bonding, the molecular weight of the benzoxazine compound (A) is preferably 400 or more although it is not particularly limited as long as the effects of the present invention are achieved. On the other hand, from the viewpoint of obtaining more sufficient flux activity, the molecular weight of the benzoxazine compound (A) is preferably 500 or less.

The benzoxazine compound (A) preferably contains at least one selected from the group consisting of compounds represented by the following formula (1), the following formula (2), the following formula (3), and the following formula (4). Note that, in the present embodiment, oligomers produced by polymerizing monomers or the like may be contained in the benzoxazine compound (A).

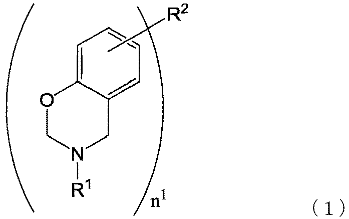

In the formula (1), each R¹ independently represents an aryl group, an aralkyl group, an alkenyl group, an alkyl group, or a cycloalkyl group. Each R² independently represents a hydrogen atom, an aryl group, an aralkyl group, an alkenyl group, an alkyl group, a cycloalkyl group, or a monovalent to tetravalent organic group represented by the general formulas (a) to (t). n¹ represents an integer of 1 to 4.

For both R¹ and R², the aryl group is preferably an aryl group having 6 to 18 carbon atoms, and examples of such an aryl group may include, for example, a phenyl group, a naphthyl group, an indenyl group, a biphenyl group, and an anthryl group. Among the above, a phenyl group is preferable. These aryl groups may have one or more, preferably in the range of 1 to 3, lower alkyl groups having 1 to 4 carbon atoms. Examples of the aryl group having such a lower alkyl group may include, for example, a tolyl group, a xylyl group, and a methylnaphthyl group.

For both R¹ and R², the aralkyl group is preferably a benzyl group or a phenethyl group, and they may have one or more, preferably in the range of 1 to 3, lower alkyl groups having 1 to 4 carbon atoms on the phenyl group thereof.

For both R¹ and R², examples of the alkenyl group may include, for example, a vinyl group, a (meth)allyl group, a propenyl group, a butenyl group, and a hexenyl group. Among the above, a vinyl group, an allyl group, and a propenyl group are preferable, and an allyl group is more preferable.

For both R¹ and R², as the alkyl group, an alkyl group having 1 to 20 carbon atoms is preferable, and an alkyl group having 1 to 10 carbon atoms is more preferable. An alkyl group having 3 or more carbon atoms may be linear or branched. Examples thereof include, for example, a methyl group, an ethyl group, a n-propyl group, an isopropyl group, a n-butyl group, an isobutyl group, a sec-butyl group, a t-butyl group, a n-pentyl group, a neopentyl group, a n-hexyl group, a thexyl group, a n-heptyl group, a n-octyl group, a n-ethylhexyl group, a n-nonyl group, and a n-decyl group.

For both R¹ and R², examples of the cycloalkyl group include, for example, a cyclopentyl group, a cyclohexyl group, and a cycloheptyl group. It is preferably a cyclohexyl group.

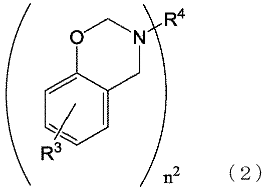

In the formula (2), each R³ independently represents a hydrogen atom, an aryl group, an aralkyl group, an alkenyl group, an alkyl group, or a cycloalkyl group. Each R⁴ independently represents an aryl group, an aralkyl group, an alkenyl group, an alkyl group, a cycloalkyl group, or a monovalent to tetravalent organic group represented by the following general formulas (a) to (o). n² represents an integer of 1 to 4.

For both R³ and R⁴, the aryl group, the aralkyl group, the alkenyl group, the alkyl group, and the cycloalkyl group are as described above.

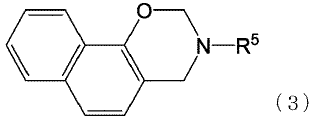

In the formula (3), each R⁵ independently represents an alkyl group, a cycloalkyl group, or a phenyl group optionally having a substituent.

The alkyl group and the cycloalkyl group in R⁵ are as described above.

Examples of the phenyl group optionally having a substituent include, for example, an unsubstituted phenyl group; a monosubstituted phenyl group such as a 4-methylphenyl group, a 3-methoxyphenyl group, a 4-cyclohexylphenyl group, and a 4-methoxyphenyl group; a disubstituted phenyl group such as a 3,5-dimethylphenyl group, a 3,4-dimethylphenyl group, and a 3,5-dimethoxyphenyl group; a trisubstituted phenyl group such as a 3,4,5-trimethylphenyl group; and a 2-naphthyl group optionally having a substituent such as a 2-naphthyl group, a 3-methyl-2-naphthyl group, and a 4-methyl-2-naphthyl group.

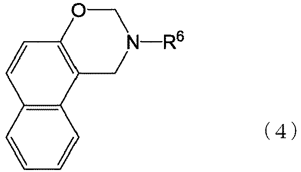

In the formula (4), each R⁶ independently represents an alkyl group, a cycloalkyl group, or a phenyl group optionally having a substituent.

The alkyl group, the cycloalkyl group, or the phenyl group optionally having a substituent in R⁶ are as described above.

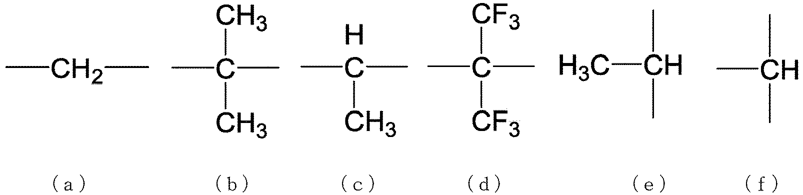

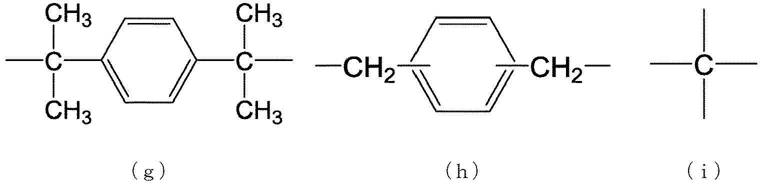

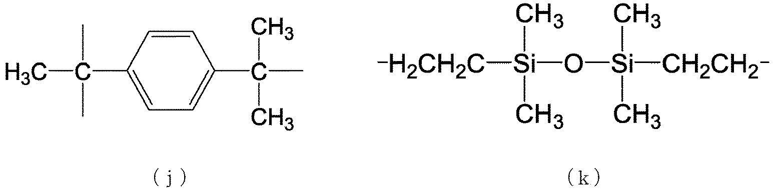

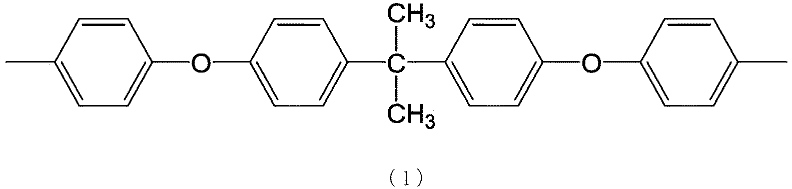

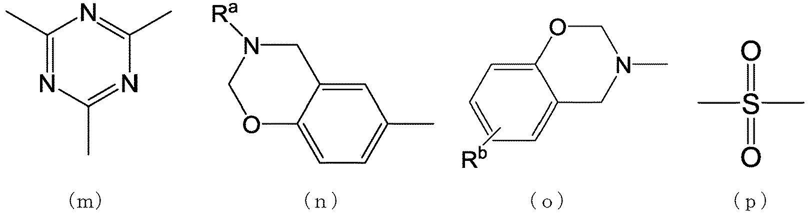

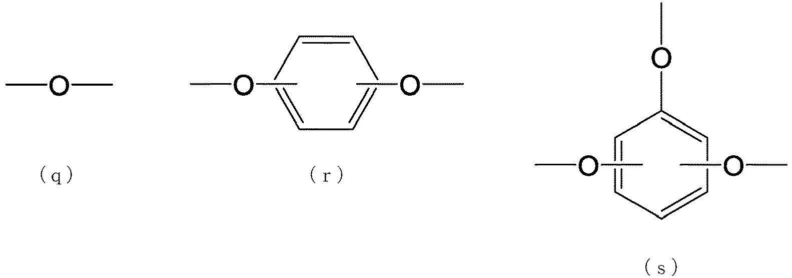

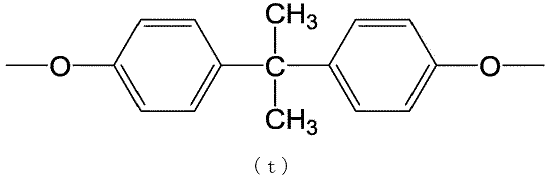

In the general formulas (a) to (t), each R^{a} independently represents an aryl group, an aralkyl group, an alkenyl group, an alkyl group, or a cycloalkyl group. Each R^{b} independently represents a hydrogen atom, an aryl group, an aralkyl group, an alkenyl group, an alkyl group, or a cycloalkyl group.

For both R^{a} and R^{b}, the aryl group, the aralkyl group, the alkenyl group, the alkyl group, and the cycloalkyl group are as described above.

The benzoxazine compound (A) preferably contains at least one selected from the group consisting of compounds represented by the following formula (5) and the following formula (6) from the viewpoint of solvent solubility.

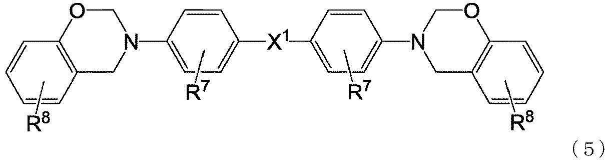

In the formula (5), each R⁷ independently represents a hydrogen atom, an aryl group, an aralkyl group, an alkenyl group, an alkyl group, or a cycloalkyl group. Each R⁸ independently represents a hydrogen atom, an aryl group, an aralkyl group, an alkenyl group, an alkyl group, or a cycloalkyl group. X¹ represents an alkylene group, a group represented by the following formula (7), a group represented by the formula "-SO₂-", a group represented by the formula "-CO-", an oxygen atom, or a single bond.

For both R⁷ and R⁸, the aryl group, the aralkyl group, the alkenyl group, the alkyl group, and the cycloalkyl group are as described above.

As the alkylene group, a linear or branched alkylene group is preferable. Examples of the linear alkylene group include, for example, a methylene group, an ethylene group, a propylene group, a butylene group, a pentylene group, a hexylene group, a heptylene group, an octylene group, a nonylene group, a decanylene group, a trimethylene group, a tetramethylene group, a pentamethylene group, and a hexamethylene group. Examples of the branched alkylene group include, for example, an alkylmethylene group such as -C(CH₃)₂-,-CH(CH₃)-, -CH(CH₂CH₃)-, -C(CH₃)(CH₂CH₃)-,-C(CH₃)(CH₂CH₂CH₃)-, and -C(CH₂CH₃)₂-; and an alkylethylene group such as -CH(CH₃)CH₂-, -CH(CH₃)CH(CH₃)-, -C(CH₃)₂CH₂-, -CH(CH₂CH₃)CH₂-, and -C(CH₂CH₃)₂-CH₂-.

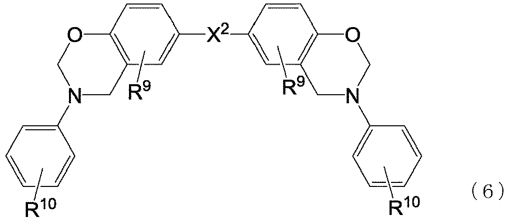

In the formula (6), each R⁹ independently represents a hydrogen atom, an aryl group, an aralkyl group, an alkenyl group, an alkyl group, or a cycloalkyl group. Each R¹⁰ independently represents a hydrogen atom, an aryl group, an aralkyl group, an alkenyl group, an alkyl group, or a cycloalkyl group. X² represents an alkylene group, a group represented by the following formula (7), a group represented by the formula "-SO₂-", a group represented by the formula "-CO-", an oxygen atom, or a single bond.

For both R⁹ and R¹⁰, the aryl group, the aralkyl group, the alkenyl group, the alkyl group, and the cycloalkyl group are as described above. The alkylene group in X² is as described above.

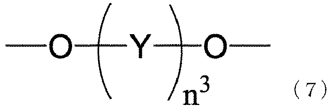

In the formula (7), Y is an alkylene group or a hydrocarbon group having 6 or more and 30 or less carbon atoms and having an aromatic ring. n³ represents an integer of 0 or more and 5 or less. n³ is preferably an integer of 1 or more and 3 or less, and is more preferably 1 or 2.

The alkylene group in Y is as described above.

Examples of the hydrocarbon group having 6 or more and 30 or less carbon atoms and having an aromatic ring include, for example, a divalent group formed by removing two hydrogen atoms from the nucleus of a compound having aromaticity such as benzene, biphenyl, naphthalene, anthracene, fluorene, phenanthrene, indacene, terphenyl, acenaphthylene, and phenalene.

The benzoxazine compound (A) preferably contains at least one selected from the group consisting of a compound represented by the following formula (5-1), a compound represented by the following formula (5-2), a compound represented by the following formula (5-3), a compound represented by the following formula (6-1), a compound represented by the following formula (6-2), and a compound represented by the following formula (6-3) from the viewpoint of obtaining excellent solvent solubility and obtaining high chip adhesiveness and substrate adhesiveness.

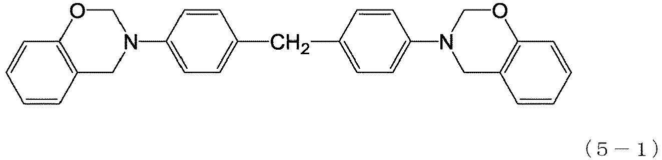

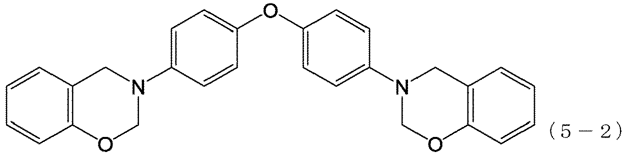

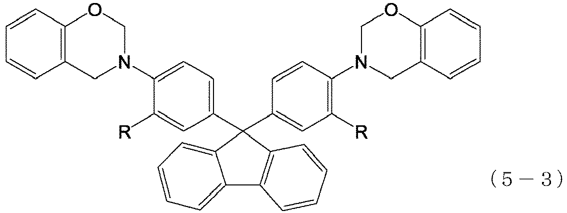

(In the formula (5-3), each R independently represents a hydrogen atom or a hydrocarbon group having 1 to 4 carbon atoms.)

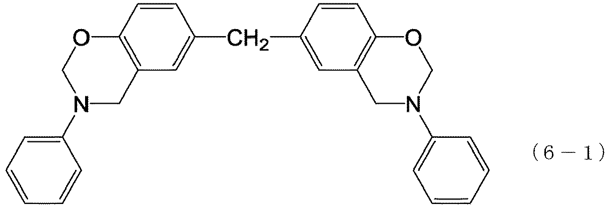

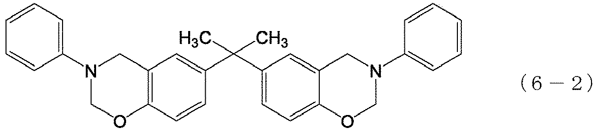

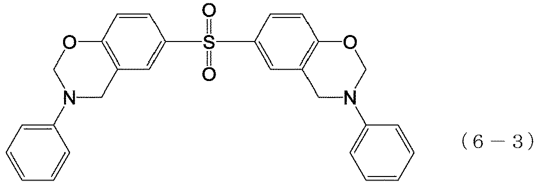

These benzoxazine compounds (A) can be used alone as one kind, or can be used in an appropriate mixture of two or more kinds.

The method for producing the benzoxazine compound (A) is not particularly limited, and it can be produced by a publicly known method. Examples of the production method include, for example, a method containing a first step of allowing a primary amine, an aldehyde, and a phenol to react in a solvent, thereby preparing a reaction solution in which a benzoxazine compound, which is a product, is dissolved or partially suspended, and a second step of adding an alcoholic solvent to the reaction solution, thereby precipitating the benzoxazine compound.

In the first step, a reaction solution containing the benzoxazine compound monomer as the main product can be obtained, and this benzoxazine compound monomer is produced by dehydration condensation of a primary amine, an aldehyde, and a phenol.

As the benzoxazine compound (A), those commercially available may be used, and examples thereof include, for example, a P-d-based benzoxazine (manufactured by SHIKOKU CHEMICALS CORPORATION) and an F-a-based benzoxazine (manufactured by SHIKOKU CHEMICALS CORPORATION).

### [1-2. Organic compound (B) having flux function]

The resin composition of the present embodiment contains the organic compound (B) having the flux function in order to exhibit flux activity during the flip chip bonding. The organic compound (B) having the flux function is not particularly limited as long as it is an organic compound having one or more acid sites in the molecule. As the acid site, for example, a phosphoric acid group, a phenolic hydroxy group, a carboxyl group, and a sulfonic acid group are preferable, and a phenolic hydroxy group or a carboxyl group is more preferable from the viewpoint of more effectively preventing migration of a metal constituting the joint, such as solder and copper, and corrosion in a semiconductor device using the resin composition of the present embodiment as an underfill material, preferably as a pre-applied underfill material.

The organic compound (B) having the flux function preferably has an acid dissociation constant pKa of 3.8 or more and 15.0 or less in order to sufficiently remove the oxidized layer at the joint, and more preferably has an acid dissociation constant pKa of 4.0 or more and 14.0 or less from the viewpoint of achieving both storage stability and flux activity of the varnish and the resin laminate.

In addition, the organic compound (B) having the flux function in the resin composition of the present embodiment preferably has a molecular weight of 200 or more, and more preferably has a molecular weight of 250 or more from the viewpoint of preventing the organic compound (B) having the flux function from being volatilized before the flux activity is exhibited during the flip chip bonding, that is, from being volatilized before the oxidized layer at the joint is removed. In order that the organic compound (B) having the flux function has mobility as an acid and sufficient flux activity is obtained, the molecular weight is preferably 8000 or less, more preferably 1000 or less, and still more preferably 500 or less.

The organic compound (B) having the flux function is preferably at least one selected from the group consisting of abietic acid, neoabietic acid, dehydroabietic acid, pimaric acid, isopimaric acid, palustric acid, diphenolic acid, dihydroabietic acid, tetrahydroabietic acid, an acid-modified rosin resin, N,N'-bis(salicylidene)-1,2-propanediamine, N,N'-bis(salicylidene)-1,3-propanediamine, and phenolphthalin from the viewpoint of solvent solubility and storage stability.

These compounds (B) can be used alone as one kind, or can be used in an appropriate mixture of two or more kinds.

Among the above, from the viewpoint of preventing deactivation caused by the benzoxazine compound (A) described above or the thermosetting component (C) described below, dehydroabietic acid, diphenolic acid, dihydroabietic acid, tetrahydroabietic acid, an acid-modified rosin resin, N,N'-bis(salicylidene)-1,2-propanediamine, and N,N'-bis(salicylidene)-1,3-propanediamine are more preferable. Since dehydroabietic acid, dihydroabietic acid, an acid-modified rosin resin, N,N'-bis(salicylidene)-1,2-propanediamine, and N,N'-bis(salicylidene)-1,3-propanediamine have relatively low reactivity, they hardly react with the benzoxazine compound (A) described above and the thermosetting component (C) described below, and are thus still more preferable from the viewpoint of maintaining sufficient flux activity necessary for removing the oxidized layer.

Although the content of the organic compound (B) having the flux function in the resin composition of the present embodiment is not particularly limited, it is preferably 1 part by mass or more and 50 parts by mass or less based on 100 parts by mass in total of the benzoxazine compound (A), the thermosetting component (C) described below, and the flexibility imparting component (F) described below, more preferably 5 parts by mass or more and 40 parts by mass or less, and still more preferably 10 parts by mass or more and 30 parts by mass or less from the viewpoint of achieving both flux activity of the resin composition and flexibility, which is one of the important characteristics upon forming and using a laminate. However, when the flexibility imparting component (F) is not contained in the resin composition of the present embodiment, the content of the organic compound (B) is the amount described above based on 100 parts by mass in total of the benzoxazine compound (A) and the thermosetting resin (C).

### [1-3. Thermosetting component (C)]

The resin composition of the present embodiment contains a thermosetting component other than the benzoxazine compound (A). Examples of the thermosetting component (C) include a compound that exhibits reactivity with the benzoxazine compound (A) and does not exhibit reactivity with a flux component, and a phenolic resin and/or a radical polymerizable thermosetting resin is preferable.

Examples of the phenolic resin include, for example, a bisphenol A-based phenolic resin, a bisphenol E-based phenolic resin, a bisphenol F-based phenolic resin, a bisphenol S-based phenolic resin, a phenol novolac resin, a bisphenol A novolac-based phenolic resin, a glycidyl ester-based phenolic resin, an aralkyl novolac-based phenolic resin, a biphenyl aralkyl-based phenolic resin, a cresol novolac-based phenolic resin, a polyfunctional phenolic resin, a naphthol resin, a naphthol novolac resin, a polyfunctional naphthol resin, an anthracene-based phenolic resin, a naphthalene skeleton-modified novolac-based phenolic resin, a phenol aralkyl-based phenolic resin, a naphthol aralkyl-based phenolic resin, a dicyclopentadiene-based phenolic resin, a biphenyl-based phenolic resin, an alicyclic phenolic resin, a polyol-based phenolic resin, a phosphorus containing phenolic resin, and a hydroxy group containing silicone resin. These phenolic resins can be used alone as one kind, or can be used in an appropriate mixture of two or more kinds.

Examples of the phenolic resin include, for example, 9,9-bis-(4-hydroxy-3-methylphenyl) fluorene, bisphenolfluorene, 2,4,6-tris(3',5'-di-tert-butyl-4'-hydroxybenzyl)mesitylene, hesperidin, α,α,α'-tris(4-hydroxyphenyl)-1-ethyl-4-isopropylbenzene, α,α'-bis(4-hydroxy-3,5-dimethylphenyl)-1,4-diisopropylbenzene, 4,4'-methylenebis(2,6-di-tert-butylphenol), 1,1,3-tris(2,5-dimethyl-4-hydroxyphenyl)-3-phenylpropane, 4,4'-[1-[4-[1-[4-hydroxyphenyl]-1-methylethyl]phenyl]ethylidene]bisphenol, 2,3,4-trihydroxybenzophenone, 2,3,4,4'-tetrahydroxybenzophenone, 2-bis(4-hydroxyphenyl)propane, tris(4-hydroxyphenyl)methane, 1,1,1-tris(4-hydroxy-3-methylphenyl)ethane, 1,1,2,2-tetrakis(4-hydroxyphenyl)ethane, an oligomer of a novolac resin, and an oligomer obtained by copolymerizing a compound having one or more phenolic hydroxy groups and dicyclopentadiene.

These phenolic resins can be used alone as one kind or can be used in an appropriate mixture of two or more kinds.

The radical polymerizable thermosetting resin is not particularly limited as long as it is a thermosetting resin having a functional group that is to be polymerized by radicals. Such a thermosetting resin is not particularly limited, and a resin or a compound having at least one or more functional groups selected from the group consisting of an alkenyl group, a maleimide group and a (meth)acryloyl group is preferable.

These radical polymerizable thermosetting resins can be used alone as one kind, or can be used in an appropriate mixture of two or more kinds.

The thermosetting resin having the alkenyl group is not particularly limited as long as it is a resin or a compound having one or more carbon-carbon double bonds in the molecule, and examples thereof include, for example, a thermosetting resin having a vinyl group, a thermosetting resin having a (meth)allyl group, and a thermosetting resin having a propenyl group.

Examples of the thermosetting resin having the vinyl group include, for example, divinylbenzene, divinylnaphthalene, styrene, and a styrene compound.

The thermosetting resin having the (meth)allyl group is not particularly limited as long as it is a resin or a compound having one or more (meth)allyl groups in the molecule, and examples thereof include, for example, tri(meth)allyl cyanurate, tri(meth)allyl isocyanurate, tri(meth)allyl trimellitate, tetra(meth)allyl pyromellitate, and pentaerythritol tri(meth)allyl ether.

The thermosetting resin having the propenyl group is not particularly limited as long as it is a resin or a compound having one or more propenyl groups in the molecule, and examples thereof include, for example, propenylphenoxybenzophenone.

As the radical polymerizable thermosetting resin, a maleimide compound is preferable from the viewpoint of reactivity with the benzoxazine compound (A).

It is not clear why a maleimide compound is preferable, but the present inventors presume the reason as follows. That is, it is presumed that, while a resin composition obtained by the addition reaction between the benzoxazine compound (A) and the maleimide compound can impart the heat resistance that the maleimide compound has, low adhesiveness, which is a weak point of a resin composition obtained by curing of the maleimide compound alone, can be improved by the benzoxazine compound (A). As the mechanism for improving the adhesiveness, it is presumed that, in addition to the introduction of polar groups such as a phenolic hydroxy group and a tertiary amino group produced over the course of the ring opening polymerization of the oxazine ring described above, by mitigating a high crosslinking density due to polymerization of maleimide groups through the addition reaction, moderate following properties to the adherend are exhibited.

The thermosetting resin having the maleimide group is not particularly limited as long as it is a resin or a compound having one or more maleimide groups in the molecule.

Examples thereof include, for example, N-phenylmaleimide, N-hydroxyphenylmaleimide, bis(4-maleimidophenyl)methane, 4,4-diphenylmethanebismaleimide, bis(3,5-dimethyl-4-maleimidophenyl)methane, bis(3-ethyl-5-methyl-4-maleimidophenyl)methane, bis(3,5-diethyl-4-maleimidophenyl)methane, phenylmethanemaleimide, o-phenylenebismaleimide, m-phenylenebismaleimide, p-phenylenebismaleimide, o-phenylenebiscitraconimide, m-phenylenebiscitraconimide, p-phenylenebiscitraconimide, 2,2-bis(4-(4-maleimidophenoxy)-phenyl)propane, 3,3-dimethyl-5,5-diethyl-4,4-diphenylmethanebismaleimide, 4-methyl-1,3-phenylenebismaleimide, 1,6-bismaleimido-(2,2,4-trimethyl)hexane, 4,4-diphenyl ether bismaleimide, 4,4-diphenyl sulfone bismaleimide, 1,3-bis(3-maleimidophenoxy)benzene, 1,3-bis(4-maleimidophenoxy)benzene, 4,4-diphenylmethanebiscitraconimide, 2,2-bis[4-(4-citraconimidophenoxy)phenyl]propane, bis(3,5-dimethyl-4-citraconimidophenyl)methane, bis(3-ethyl-5-methyl-4-citraconimidophenyl)methane, bis(3,5-diethyl-4-citraconimidophenyl)methane, polyphenylmethanemaleimide, a novolac-based maleimide compound, a biphenyl aralkyl-based maleimide compound, 2,2-bis(4-(4-maleimidophenoxy)phenyl)propane, 1,2-bis(maleimido)ethane, 1,4-bis(maleimido)butane, 1,6-bis(maleimido)hexane, N,N'-1,3-phenylenedimaleimide, N,N'-1,4-phenylenedimaleimide, N-phenylmaleimide, a maleimide compound represented by the following formula (8), a maleimide compound represented by the following formula (9), a maleimide compound represented by the following formula (10), a maleimide compound represented by the following formula (11), a maleimide compound represented by the following formula (12), and a maleimide compound represented by the following formula (13).

Among the above, from the viewpoint of solubility in an organic solvent, 2,2-bis(4-(4-maleimidophenoxy)phenyl)propane, 1,2-bis(maleimido)ethane, 1,4-bis(maleimido)butane, 1,6-bis(maleimido)hexane, N,N'-1,3-phenylenedimaleimide, N,N'-1,4-phenylenedimaleimide, N-phenylmaleimide, a maleimide compound represented by the following formula (8), a maleimide compound represented by the following formula (9), a maleimide compound represented by the following formula (10), a maleimide compound represented by the following formula (11), a maleimide compound represented by the following formula (12), and a maleimide compound represented by the following formula (13) are preferable, and 2,2-bis(4-(4-maleimidophenoxy)phenyl)propane, a maleimide compound represented by the following formula (8), a maleimide compound represented by the following formula (9), a maleimide compound represented by the following formula (10), a maleimide compound represented by the following formula (11), a maleimide compound represented by the following formula (12), and a maleimide compound represented by the following formula (13) are more preferable. As the maleimide compound represented by the following formula (10), bis-(3-ethyl-5-methyl-4-maleimidophenyl)methane is preferable.

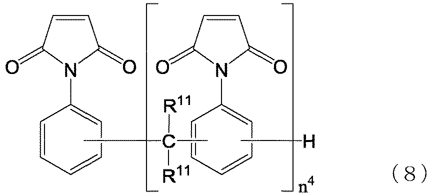

In the formula (8), each R¹¹ independently represents a hydrogen atom or a methyl group, and from the viewpoint of achieving action effects according to the present embodiment more effectively and reliably, it is preferably a hydrogen atom. In addition, in the formula (8), n⁴ represents an integer of 1 or more and 10 or less. For the upper limit value of n⁴, it is preferable that the upper limit value should be 7 from the viewpoint of solubility in an organic solvent.

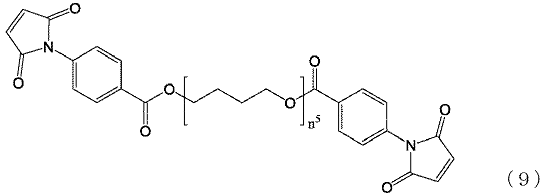

In the formula (9), the average value of n⁵ is in the range of 1 or more and 30 or less. From the viewpoint of achieving action effects according to the present embodiment more effectively and reliably, n⁵ is, as the average value, preferably 7 or more and 30 or less and more preferably 7 or more and 18 or less.

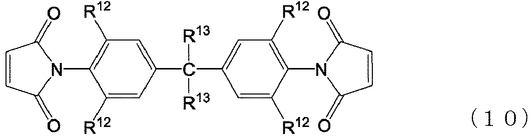

In the formula (10), each R¹² independently represents a hydrogen atom, a methyl group, or an ethyl group.

In the formula (10), each R¹³ independently represents a hydrogen atom or a methyl group.

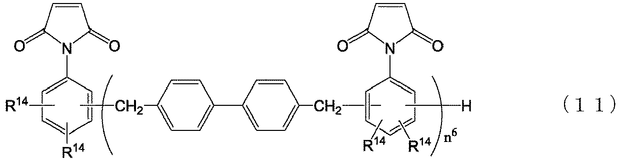

In the formula (11), each R¹⁴ independently represents a hydrogen atom, an alkyl group having 1 to 5 carbon atoms, or a phenyl group; and n⁶ represents an integer of 1 or more and 10 or less.

Examples of the alkyl group having 1 to 5 carbon atoms include, for example, a methyl group, an ethyl group, a n-propyl group, an isopropyl group, a n-butyl group, an isobutyl group, a sec-butyl group, a t-butyl group, a n-pentyl group, and a neopentyl group.

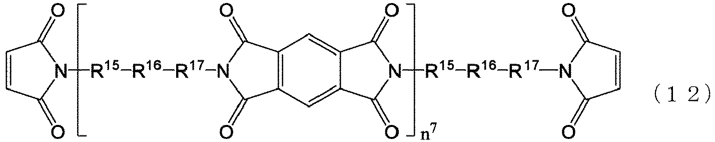

In the formula (12), R¹⁵ and R¹⁷ each independently represent a hydrocarbon group in which 8 or more atoms are linearly linked. Each R¹⁶ independently represents a substituted or unsubstituted cyclic hydrocarbon group optionally having a heteroatom in which 4 or more and 10 or less atoms constitute the ring. n⁷ represents a number of 1 or more and 10 or less.

For both R¹⁵ and R¹⁷, examples of the hydrocarbon group in which 8 or more atoms are linearly linked include, for example, a substituted or unsubstituted divalent hydrocarbon group having 8 or more carbon atoms. The substituted or unsubstituted divalent hydrocarbon group is not particularly limited, but examples thereof include a substituted or unsubstituted linear aliphatic hydrocarbon group, a substituted or unsubstituted branched aliphatic hydrocarbon group, and a substituted or unsubstituted cycloaliphatic hydrocarbon group. Examples thereof include, for example, an octylene group, a nonamethylene group, a decamethylene group, a dodecamethylene group, a hexadecamethylene group, and an octadecamethylene group.

In R¹⁶, examples of the substituted or unsubstituted cyclic hydrocarbon group optionally having a heteroatom in which 4 or more and 10 or less atoms constitute the ring include, for example, a substituted or unsubstituted alicyclic group in which 4 or more and 10 or less atoms constitute the ring, a substituted or unsubstituted aromatic group in which 4 or more and 10 or less atoms constitute the ring, and a substituted or unsubstituted heterocyclic group in which 4 or more and 10 or less atoms constitute the ring. Note that the number of atoms constituting the ring means the number of atoms linked in a cyclic manner, and does not include the number of atoms of side chain substituents and the like. Examples of the group of the alicyclic part in the substituted or unsubstituted alicyclic group include, for example, a divalent group or group with 2 or more valences such as a cyclobutyl group, a cyclopentyl group, a cyclohexyl group, a cyclooctyl group, and a cyclodecyl group. In addition, when the substituent is an alkyl group, that alkyl group is not particularly limited, but an alkyl group having 1 to 10 carbon atoms is preferable, and an alkyl group having 3 to 10 carbon atoms is more preferable. Examples of the alkyl group having 1 to 10 carbon atoms include, for example, a methyl group, an ethyl group, a n-propyl group, an isopropyl group, a n-butyl group, an isobutyl group, a sec-butyl group, a t-butyl group, a n-pentyl group, a neopentyl group, a n-hexyl group, a thexyl group, a n-heptyl group, a n-octyl group, a n-ethylhexyl group, a n-nonyl group, and a n-decyl group. The alkyl group for the alkyl group substitution may be one, or may be two or more.

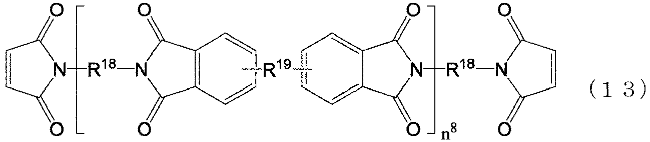

In the formula (13), each R¹⁸ independently represents an alkylene group. Each R¹⁹ independently represents an alkylene group, a group represented by the following formula (7), a group represented by the formula "-SO₂-", a group represented by the formula "-CO-", a group represented by the following formula (14), an oxygen atom, or a single bond. n⁸ represents a number of 1 or more and 10 or less.

For both R¹⁸ and R¹⁹, the alkylene group is as described above.

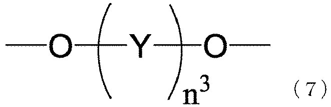

In the formula (7), Y is an alkylene group, or a hydrocarbon group having 6 or more and 30 or less carbon atoms and having an aromatic ring. n³ represents an integer of 0 or more and 5 or less. n³ is preferably an integer of 1 or more and 3 or less and is more preferably 1 or 2.

In Y, the alkylene group and the hydrocarbon group having 6 or more and 30 or less carbon atoms and having the aromatic ring are as described above.

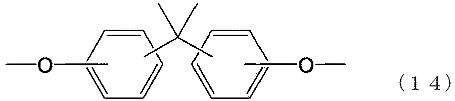

In addition, as the maleimide compound, the maleimide compound represented by the above formula (9) is preferable from the viewpoint of solubility in an organic solvent and flexibility, and it is more preferable to further contain, along with the maleimide compound represented by the above formula (9), at least one maleimide compound selected from the group consisting of 2,2-bis(4-(4-maleimidophenoxy)phenyl)propane, the maleimide compound represented by the above formula (8), and the maleimide compound represented by the above formula (10).

When the maleimide compound is used in the resin composition of the present embodiment, without particular limitations, the resin composition preferably contains a maleimide compound represented by the formula (9) at 5 to 40 parts by mass, and more preferably contains it at 10 to 35 parts by mass based on 100 parts by mass in total of the benzoxazine compound (A), the thermosetting component (C), and the flexibility imparting component (F) from the viewpoint of obtaining good solubility in an organic solvent and good flexibility. However, when the flexibility imparting component (F) is not contained in the resin composition of the present embodiment, the content of the maleimide compound is the amount described above based on 100 parts by mass in total of the benzoxazine compound (A) and the thermosetting component (C) .

The maleimide compound may also be contained in the resin composition in the form of, for example, a prepolymer obtained by polymerizing the maleimide compound or a prepolymer obtained by polymerizing the maleimide compound with another compound such as an amine compound.

As the maleimide compound, those commercially available may be used, and examples thereof include, for example, BMI-2300 manufactured by Daiwa Kasei Industry Co., LTD.; BMI-70, BMI-80, and BMI-1000P manufactured by K·I Chemical Industry Co., LTD.; and BMI-1500, BMI-1700, BMI-3000, and BMI-5000 manufactured by Designer Molecules Inc.

The thermosetting resin having the (meth)acryloyl group is not particularly limited as long as it is a resin or a compound having one or more (meth)acryloyl groups in the molecule. Examples of the thermosetting resin having the (meth)acryloyl group include, for example, methyl (meth)acrylate, ethyl (meth)acrylate, butyl (meth)acrylate, lauryl (meth)acrylate, polyethylene glycol (meth)acrylate, polyethylene glycol (meth)acrylate monomethyl ether, phenylethyl (meth)acrylate, isobornyl (meth)acrylate, cyclohexyl (meth)acrylate, benzyl (meth)acrylate, tetrahydrofurfuryl (meth)acrylate, butanediol di (meth)acrylate, hexanediol di(meth)acrylate, neopentyl glycol di(meth)acrylate, nonanediol di(meth)acrylate, glycol di(meth)acrylate, diethylene di(meth)acrylate, polyethylene glycol di(meth)acrylate, tris(meth)acryloyloxyethyl isocyanurate, polypropylene glycol di(meth)acrylate, adipic acid epoxy di(meth)acrylate, bisphenol ethylene oxide di(meth)acrylate, hydrogenated bisphenol ethylene oxide (meth)acrylate, bisphenol di(meth)acrylate, ε-caprolactone-modified hydroxypivalic acid neopentyl glycol di(meth)acrylate, ε-caprolactone-modified dipentaerythritol hexa(meth)acrylate, ε-caprolactone-modified dipentaerythritol poly(meth)acrylate, dipentaerythritol poly(meth)acrylate, trimethylolpropane tri(meth)acrylate, triethylolpropane tri(meth)acrylate and an ethylene oxide adduct thereof, pentaerythritol tri(meth)acrylate and an ethylene oxide adduct thereof, pentaerythritol tetra(meth)acrylate, and dipentaerythritol hexa(meth)acrylate and an ethylene oxide adduct thereof. If necessary, for example, a polymerization inhibitor such as hydroquinone and a methyl ether hydroquinone may be used as appropriate.

These thermosetting components (C) can be used alone as one kind, or can be used in a mixture of two or more kinds.

The content of the thermosetting component (C) in the resin composition of the present embodiment is not particularly limited, but the resin composition preferably contains the thermosetting component (C) at 10 parts by mass or more and 80 parts by mass or less, and more preferably contains it at 15 parts by mass or more and 75 parts by mass or less based on 100 parts by mass in total of the benzoxazine compound (A) and the thermosetting component (C) since it is within the range of not impairing the adhesiveness that the above benzoxazine compound (A) has.

When the resin composition of the present embodiment contains the flexibility imparting component (F), the content of the thermosetting component (C) in the resin composition of the present embodiment is not particularly limited, but the resin composition preferably contains the thermosetting component (C) at 10 parts by mass or more and 70 parts by mass or less, and more preferably contains it at 15 parts by mass or more and 68 parts by mass or less based on 100 parts by mass in total of the benzoxazine compound (A), the thermosetting component (C), and the flexibility imparting component (F) since it is within the range of not impairing the adhesiveness that the above benzoxazine compound (A) has.

### [1-4. Radical polymerization initiator (D)]

It is preferable that the resin composition of the present embodiment should contain a radical polymerization initiator (D) as a publicly known initiator that is generally used for radical polymerization.

Although the 10 hour half-life period temperature of the radical polymerization initiator (D) is not particularly limited, it is 100°C or higher, and is more preferably 110°C or higher from the viewpoint of producibility. In the present embodiment, it is preferable that the 10 hour half-life period temperature of the radical polymerization initiator (D) should satisfy the range described above because the temperature during the solvent removal step upon production can be increased.

Examples of the radical polymerization initiator include, for example, an organic peroxide including a ketone peroxide such as dicumyl peroxide, di(2-tert-butylperoxyisopropyl)benzene, 1,1,3,3-tetramethylbutyl hydroperoxide, 2,5-dimethyl-2,5-bis(tert-butylperoxy)hexyne-3, benzoyl peroxide, di-t-butyl peroxide, methyl ethyl ketone peroxide, and cyclohexanone peroxide; a peroxy ketal such as 1,1-di(t-butylperoxy)cyclohexane and 2,2-di(4,4-di(t-butylperoxy)cyclohexyl)propane; a hydroperoxide such as tert-butyl hydroperoxide, p-menthane hydroperoxide, diisopropylbenzene hydroperoxide, cumene hydroperoxide, and t-butyl hydroperoxide; a dialkyl peroxide such as di(2-t-butylperoxyisopropyl)benzene, 2,5-dimethyl-2,5-di(t-butylperoxy)hexane, t-butyl cumyl peroxide, di-t-hexyl peroxide, 2,5-dimethyl-2,5-di(t-butylperoxy)hexyne-3, and di-t-butyl peroxide; a diacyl peroxide such as dibenzoyl peroxide and di(4-methylbenzoyl) peroxide; a peroxy dicarbonate such as di-n-propyl peroxydicarbonate and diisopropyl peroxydicarbonate; a peroxy ester such as 2,5-dimethyl-2,5-di(benzoylperoxy)hexane, t-hexyl peroxybenzoate, t-butyl peroxybenzoate, and t-butyl peroxy-2-ethyl hexanoate;
an azo compound such as 2,2'-azobisbutyronitrile, 2,2'-azobis(2,4-dimethylvaleronitrile), and 2,2'-azobis(4-methoxy-2,4-dimethylvaleronitrile); an alkylphenone-based photopolymerization initiator; an acylphosphine oxide-based photopolymerization initiator; and a titanocene-based photopolymerization initiator. In the present embodiment, an organic peroxide is preferable; an organic peroxide having a peroxy ester, a peroxy ketal, a dialkyl peroxide, or a hydroperoxide skeleton is more preferable; and dicumyl peroxide, di(2-tert-butylperoxyisopropyl)benzene, 1,1,3,3-tetramethylbutyl hydroperoxide, 2,5-dimethyl-2,5-bis(tert-butylperoxy)hexyne-3, and tert-butyl hydroperoxide are still more preferable from the viewpoint of producibility.

These radical polymerization initiators (D) can be used alone as one kind, or can be used in a mixture of two or more kinds. Also, a publicly known curing accelerator may be used in combination.

Although the content of the radical polymerization initiator (D) in the resin composition of the present embodiment is not particularly limited, it is preferably 0.05 parts by mass or more and 10 parts by mass or less based on 100 parts by mass in total of the benzoxazine compound (A) and the thermosetting component (C).

### [1-4. Inorganic filler (E)]

The resin composition of the present embodiment can contain an inorganic filler (E) in order to improve burning resistance, to improve thermal conductivity, and to reduce the thermal expansion coefficient. By using an inorganic filler, the burning resistance and thermal conductivity of the resin composition and the like can be improved, and the thermal expansion coefficient can be reduced.

Although the average particle diameter of the inorganic filler (E) is not limited, it is preferably 3 µm or less and more preferably 1 µm or less from the viewpoint of coping with narrower electrode pitch arranged on the chip and narrower gap between the electrodes when the resin composition of the present embodiment is used as an underfill material, preferably as a pre-applied underfill material. The lower limit value of the average particle diameter is not particularly limited, but it is, for example, 10 nm. Note that the "average particle diameter" of the inorganic filler (E) as used herein means the median diameter of the inorganic filler (E). Here, the median diameter means a certain particle diameter such that, when the particle size distribution of powder is divided into two parts based on that particle diameter, the volume of particles on the side of larger particle diameter and the volume of particles on the side of smaller particle diameter each account for 50% of the entire powder. The average particle diameter (median diameter) of the inorganic filler (E) is measured according to the wet laser diffraction scattering method.

The type of the inorganic filler (E) is not particularly limited, but examples thereof include, for example, a silica such as natural silica, fused silica, amorphous silica, and hollow silica; an aluminum compound such as boehmite, aluminum hydroxide, alumina, and aluminum nitride; a magnesium compound such as magnesium oxide and magnesium hydroxide; a calcium compound such as calcium carbonate and calcium sulfate; a molybdenum compound such as molybdenum oxide and zinc molybdate; boron nitride; barium sulfate; a talc such as natural talc and calcined talc; mica; and a glass such as short fibrous glass, spherical glass, and fine powder glass (for example, E glass, T glass, D glass). In addition, when it is desired to impart electrical conductivity or anisotropic electrical conductivity to the resin composition, metal particles of, for example, gold, silver, nickel, copper, tin alloy, and palladium may be used as the inorganic filler (E).

Among the above, from the viewpoint of improving the burning resistance and reducing the thermal expansion coefficient of the resin composition, as the inorganic filler (E), silica, aluminum hydroxide, alumina, boehmite, boron nitride, aluminum nitride, magnesium oxide, and magnesium hydroxide are preferable, and silica, alumina, and boron nitride are more preferable. Among the above, fused silica is still more preferable. Examples of the fused silica include, for example, SFP-120MC and SFP-130MC manufactured by Denka Company Limited; and 0.3 µm SX-CM1, 0.3 µm SX-EM1, 0.3 µm SV-EM1, SC1050-MLQ, SC2050-MNU, SC2050-MTX, 2.2 µm SC6103-SQ, SE2053-SQ, YA050C-MJF, and YA050C-MJA manufactured by Admatechs Company Limited.

These inorganic fillers (E) can be used alone as one kind, or can be used in an appropriate mixture of two or more kinds.

As the inorganic filler (E), those surface-treated with a silane coupling agent may be used.

The silane coupling agent is not particularly limited as long as it is a silane coupling agent generally used for the surface treatment of inorganic matters. Examples thereof include, for example, a vinylsilane-based silane coupling agent such as vinyltrimethoxysilane and γ-methacryloxypropyltrimethoxysilane; a phenylaminosilane-based silane coupling agent such as N-phenyl-3-aminopropyltrimethoxysilane; a phenylsilane-based silane coupling agent such as trimethoxyphenylsilane; and an imidazolesilane-based silane coupling agent. These silane coupling agents can be used alone as one kind, or can be used in an appropriate mixture of two or more kinds.

When the inorganic filler (E) is used, its content in the resin composition is preferably 500 parts by mass or less and more preferably 300 parts by mass or less based on 100 parts by mass in total of the benzoxazine compound (A), the thermosetting component (C), and the flexibility imparting component (F) from the viewpoint of ensuring the flowability of an underfill material, suitably a pre-applied underfill material, in the joint process while improving the burning resistance and reducing the thermal expansion coefficient of the resin composition. In addition, the content is preferably 10 parts by mass or more, more preferably 20 parts by mass or more, and still more preferably 50 parts by mass or more. However, when the flexibility imparting component (F) is not contained in the resin composition of the present embodiment, the content of the inorganic filler (E) is the amount described above based on 100 parts by mass in total of the benzoxazine compound (A) and the thermosetting resin (C). Note that, when two or more kinds of inorganic fillers (E) are used in combination, it is preferable that their total amount should satisfy the content range described above.

### [I-5. Flexibility imparting component (F)]

It is preferable that the resin composition of the present embodiment should contain a flexibility imparting component (F). Although the flexibility imparting component (F) is not particularly limited as long as it is a component that can impart flexibility to a layer containing the resin composition, examples thereof include, for example, a thermoplastic polymer compound such as a polyimide, a polyamide imide, a polystyrene, a polyolefin, a styrene-butadiene rubber (SBR), an isoprene rubber (IR), a butadiene rubber (BR), a (meth)acrylonitrile-butadiene rubber (NBR), a polyurethane, a polypropylene, a (meth)acrylic oligomer, a (meth)acrylic polymer, and a silicone resin.

These flexibility imparting components (F) can be used alone as one kind, or can be used in an appropriate mixture of two or more kinds.

Among the above, a (meth)acrylic oligomer or a (meth)acrylic polymer is preferable from the viewpoint of solubility in an organic solvent that is used upon producing the resin composition, compatibility with the maleimide compound, controllability of the melt viscosity of the resin composition, and impartment of flexibility. Examples of the (meth)acrylic oligomer and the (meth)acrylic polymer include, for example, the "ARUFON (registered trademark)" series from Toagosei Co., Ltd.; the "ACTFLOW (registered trademark)" series from Soken Chemical & Engineering Co., Ltd.; the "PARACRON (registered trademark)" series from Negami Chemical Industrial Co., Ltd.; and the "KURARITY (registered trademark)" series from KURARAY CO., LTD.

Although the molecular weight of the flexibility imparting component (F) is not particularly limited, the mass average molecular weight is preferably 1,000 or more, and is more preferably 2,000 or more from the viewpoint of imparting flexibility to the resin composition. In addition, when the resin composition is used as an underfill material, suitably as a pre-applied underfill material, in order to obtain a joint with a good and stable shape without entrapment of the resin composition into the metal joint, it is necessary to control the melt viscosity of the resin composition at a low level and to ensure the flowability of the resin composition upon the joint process. From such a viewpoint, the mass average molecular weight of the flexibility imparting component (E) is preferably 1,000,000 or less, more preferably 800,000 or less, still more preferably 100,000 or less, and even more preferably 10,000 or less. By using a flexibility imparting component (E) having a mass average molecular weight in the above range, both flexibility of the resin composition and joinability in the case of being used as an underfill material, suitably as a pre-applied underfill material can be achieved in a more well balanced manner. Note that the "mass average molecular weight" of the flexibility imparting component (E) as used herein means a mass average molecular weight by a gel permeation chromatography (GPC) method in terms of polystyrene standard.

When the flexibility imparting component (F) is used, its content in the resin composition is preferably 87.5 parts by mass or less, more preferably 50 parts by mass or less, and more preferably 30 parts by mass or less based on 100 parts by mass in total of the benzoxazine compound (A), the thermosetting component (C), and the flexibility imparting component (F) from the viewpoint of controllability of melt viscosity. In addition, the content of the flexibility imparting component (F) in the resin composition is preferably 1 part by mass or more, and more preferably 5 parts by mass or more. Note that, when two or more kinds of flexibility imparting components (F) are used in combination, it is preferable that their total amount should satisfy the ratio described above.

### [1-6. Additional component]

The resin composition of the present embodiment may contain, in addition to the benzoxazine compound (A), the organic compound (B) having the flux function, the thermosetting component (C), the radical polymerizable initiator (D), the inorganic filler (E), and the flexibility imparting component (F), one kind of or two or more kinds of additional components.

For example, the resin composition of the present embodiment may contain a coupling agent for the purpose of improving the adhesiveness at the interface between the resin and the filler and improving the moisture absorption heat resistance. Examples thereof include, for example, a vinylsilane-based silane coupling agent such as vinyltrimethoxysilane and γ-methacryloxypropyltrimethoxysilane; a phenylaminosilane-based silane coupling agent such as N-phenyl-3-aminopropyltrimethoxysilane; a phenylsilane-based silane coupling agent such as trimethoxyphenylsilane; and an imidazolesilane-based silane coupling agent. These silane coupling agents can be used alone as one kind or can be used in an appropriate mixture of two or more kinds.

When the coupling agent is used, its content in the resin composition is not particularly limited, but the content of the coupling agent is preferably 0.05 parts by mass and 20 parts by mass or less, and is more preferably 0.1 parts by mass and 15 parts by mass or less based on 100 parts by mass in total of the benzoxazine compound (A), the thermosetting component (C), and the flexibility imparting component (F) from the viewpoint of improving the moisture absorption heat resistance and reducing the volatilization volume upon the flip chip bonding. However, when the flexibility imparting component (F) is not contained in the resin composition of the present embodiment, the content of the coupling agent is the amount described above based on 100 parts by mass in total of the benzoxazine compound (A) and the thermosetting resin (C). Note that, when two or more kinds of silane coupling agents are used in combination, it is preferable that their total amount should be within the content range described above.

The resin composition of the present embodiment may contain a wetting and dispersing agent for the purpose of, for example, improving the producibility of a laminate, the dispersibility of the filler, and the like. The wetting and dispersing agent is not particularly limited as long as it is a wetting and dispersing agent that is used in general for a paint and the like. Examples thereof include, for example, Disperbyk (registered trademark)-110, 111, 180 and 161, and BYK-W996, W9010 and W903 manufactured by BYK Japan KK. These wetting and dispersing agents can be used alone as one kind, or can be used in an appropriate mixture of two or more kinds.

When the wetting and dispersing agent is used, its content in the resin composition is not particularly limited, but it is preferably 0.1 parts by mass or more and 5 parts by mass or less, and is more preferably 0.5 parts by mass or more and 3 parts by mass or less based on 100 parts by mass of the inorganic filler (E) from the viewpoint of improving the producibility of a laminate.

Note that, when two or more kinds of wetting and dispersing agents are used in combination, it is preferable that their total amount should satisfy the ratio described above.

The resin composition of the present embodiment may contain a curing accelerator for the purpose of adjusting the cure rate, and the like. The curing accelerator is not particularly limited as long as it is publicly known as a curing accelerator for a thermosetting resin and is generally used. Examples of the curing accelerator include, for example, an imidazole such as 2-ethyl-4-methylimidazole, 2-phenyl-4-methylimidazole, 1-benzyl-2-phenylimidazole, 2,4,5-triphenylimidazole, and a derivative thereof; and a tertiary amine such as triethylamine and tributylamine. These curing accelerators can be used alone as one kind, or can be used in an appropriate mixture of two or more kinds.

When the curing accelerator is used, its content in the resin composition is not particularly limited, but the content of the curing accelerator is preferably 0.01 parts by mass or more and 10 parts by mass or less, more preferably 0.05 parts by mass or more and 2 parts by mass or less, and still more preferably 0.1 parts by mass or more and 1 part by mass or less based on 100 parts by mass in total of the benzoxazine compound (A), the thermosetting component (C), and the flexibility imparting component (F) from the viewpoint of adjusting the cure rate. However, when the flexibility imparting component (F) is not contained in the resin composition of the present embodiment, the content of the curing accelerator is the amount described above based on 100 parts by mass in total of the benzoxazine compound (A) and the thermosetting resin (C). Note that, when two or more kinds of curing accelerators are used in combination, it is preferable that their total amount should satisfy the ratio described above.

The resin composition of the present embodiment may contain a variety of additive agents for various purposes in the range in which the expected characteristics are not impaired. Examples of the additive agent include, for example, an ultraviolet absorbing agent, an antioxidant, a photopolymerization initiator, a fluorescent brightening agent, a photosensitizer, a dye, a pigment, a thickening agent, a lubricant, a defoaming agent, a leveling agent, a brightening agent, a flame retardant, and an ion trapping agent. These additive agents can be used alone as one kind, or can be used in an appropriate mixture of two or more kinds.

Although the content of the additional additive agent in the resin composition of the present embodiment is not particularly limited, the content of each additive agent is normally 0.01 to 10 parts by mass based on 100 parts by mass in total of the benzoxazine compound (A), the thermosetting component (C), and the flexibility imparting component (F). However, when the flexibility imparting component (F) is not contained in the resin composition of the present embodiment, the content of the additional additive agent is the amount described above based on 100 parts by mass in total of the benzoxazine compound (A) and the thermosetting resin (C).

The resin composition of the present embodiment is prepared by appropriately mixing the benzoxazine compound (A), the organic compound (B) having the flux function, the thermosetting component (C), the radical polymerizable initiator (D), the inorganic filler (E), the flexibility imparting component (F), and additional components. If required, the resin composition may be in the form of a varnish formed by dissolving or dispersing these components in an organic solvent. The varnish of the resin composition of the present embodiment can be suitably used as a varnish upon fabricating a laminate of the present embodiment, as described below. The organic solvent is not particularly limited as long as it can suitably dissolve or disperse each of the components described above and does not impair the expected effects of the resin composition of the present embodiment. Examples of the organic solvent include, for example, an alcohol such as methanol, ethanol, and propanol; a ketone such as acetone, methyl ethyl ketone (hereinafter, may be abbreviated as "MEK"), and methyl isobutyl ketone; an amide such as dimethylacetamide and dimethylformamide; and an aromatic hydrocarbon such as toluene and xylene. These organic solvents can be used alone as one kind, or can be used in an appropriate mixture of two or more kinds.

The resin composition of the present embodiment is excellent in adhesiveness to the chip, adhesiveness to the substrate, and flux activity. In addition, by coating a supporting material with the resin composition, a laminate having a resin layer that is excellent in adhesiveness to the chip can be provided. When the resin composition of the present embodiment is used as a pre-applied underfill material for the use in the form of a laminate, it is not only excellent in adhesiveness to the chip, adhesiveness to the substrate, and flux activity, but also excellent in joinability, insulation reliability, and the like, which can also demonstrate other suitable effects. As described above, the resin composition of the present embodiment has a variety of excellent features, and in particular, it can satisfy adhesiveness to the chip, adhesiveness to the substrate, and flux activity at a high level. Therefore, the resin composition of the present embodiment is useful as an underfill material, and is more useful as a pre-applied underfill material.

### [II. Laminate, semiconductor wafer with resin composition layer fabricated by using laminate, substrate with resin composition layer fabricated by using laminate, and semiconductor device]

The laminate, semiconductor wafer with a resin composition layer, substrate with a resin composition layer such as a substrate for mounting a semiconductor with a resin composition layer, and semiconductor device of the present embodiment are all formed by using the above resin composition of the present invention.

### [II-1. Laminate]

The laminate of the present embodiment contains a supporting material and a layer containing the resin composition of the present embodiment laminated on the supporting material. In such a laminate, the above resin composition of the present embodiment is attached to a supporting material. As the supporting material, there is no particular limitation, but a polymer film can be used. Examples of the material of the polymer film include, for example, a film containing at least one or more resins selected from the group consisting of a polyvinyl chloride, a polyvinylidene chloride, a polybutene, a polybutadiene, a polyurethane, an ethylenevinyl acetate copolymer, a polyester such as a polyethylene terephthalate, a polyethylene naphthalate and a polybutylene terephthalate, a polyethylene, a polypropylene, an ethylene-propylene copolymer, a polymethylpentene, a polyimide, and a polyamide; and a mold releasing film formed by coating the surface of these films with a mold releasing agent. Among the above, a polyester, a polyimide, and a polyamide are preferable, and even among them, a polyethylene terephthalate, which is one kind of polyester, is more preferable.

Although the thickness of the supporting material of the present embodiment is not limited, it is preferably 10 to 100 µm from the viewpoint of producibility of the laminate, for example, stability of the coating thickness in the case of coating the supporting material with the resin composition. In addition, also from the viewpoint of conveyance properties of the laminate, the thickness of the supporting material is preferably 10 to 100 µm. Moreover, the lower limit of the thickness is more preferably 12 µm or more, still more preferably 25 µm or more, and even more preferably 30 µm or more from the viewpoint of ensuring the yield upon producing the laminate. In addition, the upper limit of the thickness is more preferably 80 µm or less and is still more preferably 50 µm or less from the viewpoint of production costs of the laminate because the supporting material is peeled in the middle of the process and is not present in the end as a constituent member of the semiconductor device.

The method for producing the laminate of the present embodiment by forming a layer containing the resin composition of the present embodiment (hereinafter, also simply referred to as a "resin composition layer") on the supporting material described above is not particularly limited. Examples of such a production method include, for example, an approach in which the surface of the supporting material described above is coated with a varnish formed by dissolving or dispersing the resin composition of the present embodiment in an organic solvent, and dried under heating and/or reduced pressure, and the solvent is removed to solidify the resin composition of the present embodiment, thereby forming the resin composition layer. The drying conditions are not particularly limited, but the drying is carried out such that the content ratio of the organic solvent to the resin composition layer is usually 10 parts by mass or less, and preferably 5 parts by mass or less based on the total amount of the resin composition layer (100 parts by mass). Conditions for achieving such drying vary depending on the type of the organic solvent in the varnish and the amount to be compounded. For example, for a resin composition of the benzoxazine compound (A), the thermosetting component (C), and the flexibility imparting component (F), if a varnish contains MEK at 10 to 120 parts by mass based on 100 parts by mass in total of the above components, the varnish is generally dried under heating conditions of 90 to 160°C at 1 atm for approximately 3 to 10 minutes. Although the thickness of the resin composition layer in the laminate of the present embodiment is not particularly limited, it is suitably in the range of 5 to 500 µm, and is more preferably in the range of 10 to 100 µm from the viewpoint of removing light volatile portions in a better manner upon drying the resin composition layer and from the viewpoint of achieving functions as the laminate more effectively and reliably.

### [II-2. Semiconductor wafer with resin composition layer fabricated by using laminate and substrate with resin composition layer fabricated by using laminate]

The semiconductor wafer with the resin composition layer of the present embodiment contains a semiconductor wafer and a resin composition layer in the laminate described above, which is laminated on the semiconductor wafer, and it is formed of the above laminate of the present embodiment and the semiconductor wafer. Also, the substrate with the resin composition layer of the present embodiment contains a substrate and a resin composition layer in the laminate described above, which is laminated on the substrate, and it is formed of the above laminate of the present embodiment and the substrate.

The method for fabricating the semiconductor wafer with the resin composition layer of the present embodiment is not particularly limited, but for example, it is obtained by pasting the semiconductor wafer and the resin composition layer together such that the resin composition layer of the laminate of the present embodiment and the surface of the semiconductor wafer on which the electrodes have been formed, that is, the surface on which the joint with the substrate will take place, face each other. In addition, the method for fabricating the substrate with the resin composition layer of the present embodiment is not particularly limited, but for example, it is obtained by pasting the substrate and the resin composition layer together such that the resin composition layer of the laminate of the present embodiment and the surface of the substrate on which chips are mounted face each other.

Although the method for pasting the laminate of the present embodiment and the semiconductor wafer or substrate together is not particularly limited, a vacuum pressing laminator can be suitably used. In this case, a method is preferable in which pressure is applied to the laminate of the present embodiment via an elastic body such as rubber, thereby pasting the laminate and the semiconductor wafer or substrate together. The lamination conditions are not particularly limited as long as they are conditions generally used in the art, and for example, the lamination is performed at a temperature of 50 to 140°C, with a contact pressure in the range of 1 to 11 kgf/cm², and under an atmospheric reduced pressure of 20 hPa or less. Subsequently to the lamination step, smoothing of the pasted laminate may be performed through hot pressing with metal plates. The above lamination step and the smoothing step can be performed sequentially with a commercially available vacuum pressing laminator. In the laminate stuck to the semiconductor wafer or substrate, removal of the supporting material is performed before the flip chip bonding in any case.

### [II-3. Semiconductor device]

The semiconductor device of the present embodiment contains the semiconductor wafer with the resin composition layer of the present embodiment and/or the substrate with the resin composition layer of the present embodiment, and is constituted with the resin composition layer of the present embodiment, a chip, a substrate, and the like. Although the method for producing the semiconductor device of the present embodiment is not particularly limited, and examples thereof include, for example, an approach in which the semiconductor wafer with the resin composition layer of the present embodiment is thinned with a grinding means or the like, and is divided into individual pieces with a dicing saw or the like to make a chip with the resin composition layer, which are then mounted on the substrate. In addition, a chip may be mounted on the substrate with the resin composition layer of the present embodiment. In the method for mounting the chip with the resin composition layer on the substrate and the method for mounting a semiconductor chip on the substrate with the resin composition layer, a flip chip bonder compatible with the thermocompression bonding method can be suitably used. In addition, although the case in which the chip is mounted on the substrate in the form of flip chip bonding is described for convenience in the present embodiment, the object to which the resin composition of the present embodiment is applied while mounting the chip in the form of flip chip bonding does not need to be a substrate. For example, the resin composition of the present embodiment may be used for a joint between a semiconductor wafer and a chip upon mounting the chip on the semiconductor wafer or for a joint between chips of a chip laminate in which inter-chip connection is formed via TSV (Through Silicon Via) or the like, and in any case, the superiority according to the present invention can be obtained.

### Examples

Hereinafter, the present invention will be described in detail with reference to Examples and Comparative Examples, but the present invention is not limited to these Examples in any way.

### [1. Fabrication of resin compositions and resin laminates]

### (Example 1)

As the benzoxazine compound (A), 160 parts by mass (80 parts by mass in terms of non-volatile portions) of a solution of a benzoxazine compound of the above general formula (5-1) (a P-d-based benzoxazine manufactured by SHIKOKU CHEMICALS CORPORATION) in MEK (non-volatile portions 50% by mass); as the organic compound (B) having the flux function, 40 parts by mass (20 parts by mass in terms of non-volatile portions) of a solution of dehydroabietic acid (molecular weight: 300.44, pKa: 4 to 5, functional group equivalent weight of the acid site: 300 g/eq., manufactured by Wako Pure Chemical Industries, Ltd.) in MEK (non-volatile portions 50% by mass); as the thermosetting components (C), 10 parts by mass (5 parts by mass in terms of non-volatile portions) of a solution of a maleimide compound wherein all R¹¹ in the above formula (8) is a hydrogen atom and n⁴ is 1 to 3 (BMI-2300, manufactured by Daiwa kasei Industry Co., LTD.) in MEK (non-volatile portions 50% by mass) and 30 parts by mass (15 parts by mass in terms of non-volatile portions) of a solution of a maleimide compound represented by the above formula (9) (n⁵ in the above formula (9) is 14 (average value), BMI-1000P, manufactured by K·I Chemical Industry Co., LTD.) in MEK (non-volatile portions 50% by mass); as the inorganic filler (E), 153.8 parts by mass (100 parts by mass in terms of non-volatile portions) of a slurry silica (average particle diameter: 0.3 µm, non-volatile portions 65% by mass, 0.3 µm SX-CM1 manufactured by Admatechs Company Limited., phenylaminosilane-treated); and as the radical polymerization initiator, 0.5 parts by mass of dicumyl peroxide (10 hour half-life period temperature: 116.4°C, manufactured by Kishida Chemical Co., Ltd.) were mixed and stirred for 30 minutes by using a high speed stirring apparatus, thereby obtaining a varnish. With this varnish, a polyethylene terephthalate film having a thickness of 38 µm (TR1-38, manufactured by UNITIKA LTD.), the surface of which was coated with a mold releasing agent, was coated, and it was heated and dried at 100°C for 5 minutes, thereby obtaining a resin laminate with the resin composition layer of the present embodiment having a thickness of 30 µm.

### (Example 2)

A varnish was prepared in the same manner as in Example 1 except that the amount of the benzoxazine compound of the above general formula (5-1) as the benzoxazine compound (A) was changed from 80 parts by mass to 20 parts by mass in terms of non-volatile portions, that the amount of the maleimide compound of the above formula (8) and the amount of the maleimide compound of the above formula (9) as the thermosetting components (C) were changed from 5 parts by mass to 45 parts by mass in terms of non-volatile portions and from 15 parts by mass to 25 parts by mass in terms of non-volatile portions, respectively, and that 10 parts by mass of an acrylic polymer (mass average molecular weight: 2900, ARUFON (registered trademark) US-6170 manufactured by Toagosei Co., Ltd.) as the flexibility imparting component (F) was mixed in, thereby obtaining a resin laminate.

### (Example 3)

A varnish was prepared in the same manner as in Example 1 except that 20 parts by mass of dipentaerythritol hexaacrylate (DPHA manufactured by Nippon Kayaku Co., Ltd.) was used as the thermosetting component (C) instead of the maleimide compound of the above formula (8) and the maleimide compound of the above formula (9), and that 0.5 parts by mass of tert-butyl hydroperoxide (LUPEROX TBH manufactured by ARKEMA Yoshitomi, Ltd., 10 hour half-life period temperature: 165°C) was used as the radical polymerization initiator instead of dicumyl peroxide, thereby obtaining a resin laminate.

### (Example 4)

A varnish was prepared in the same manner as in Example 1 except that 5 parts by mass of the maleimide compound of the above formula (8) was not compounded and the amount of the maleimide compound of the above formula (9) as the thermosetting component (C) was changed from 15 parts by mass to 10 parts by mass in terms of non-volatile portions, and that 10 parts by mass of an acrylic polymer (ARUFON (registered trademark) US-6170 manufactured by Toagosei Co., Ltd.) as the flexibility imparting component (F) was mixed in, thereby obtaining a resin laminate.

### (Example 5)

As the benzoxazine compound (A), 50 parts by mass (25 parts by mass in terms of non-volatile portions) of a solution of a benzoxazine compound of the above general formula (5-1) (a P-d-based benzoxazine manufactured by SHIKOKU CHEMICALS CORPORATION) in MEK (non-volatile portions 50% by mass); as the thermosetting components (C), 16 parts by mass (8 parts by mass in terms of non-volatile portions) of a solution of a maleimide compound wherein all R¹¹ in the above formula (8) is a hydrogen atom and n⁴ is 1 to 3 (BMI-2300, manufactured by Daiwa kasei Industry Co., LTD.) in MEK (non-volatile portions 50% by mass), 32 parts by mass (16 parts by mass in terms of non-volatile portions) of a solution of bis-(3-ethyl-5-methyl-4-maleimidophenyl)methane (BMI-70, manufactured by K·I Chemical Industry Co., LTD.) in MEK (non-volatile portions 50% by mass), 32 parts by mass (16 parts by mass in terms of non-volatile portions) of a solution of 2,2-bis(4-(4-maleimidophenoxy)phenyl)propane (BMI-80, manufactured by K·I Chemical Industry Co., LTD.) in MEK (non-volatile portions 50% by mass), and 50 parts by mass (25 parts by mass in terms of non-volatile portions) of a solution of a maleimide compound represented by the above formula (9) (n⁵ in the above formula (9) is 14 (average value), BMI-1000P, manufactured by K·I Chemical Industry Co., LTD.) in MEK (non-volatile portions 50% by mass); as the flexibility imparting component (F), 10 parts by mass of an acrylic polymer (ARUFON (registered trademark) US-6170 manufactured by Toagosei Co., Ltd.); as the organic compound (B) having the flux function, 40 parts by mass (20 parts by mass in terms of non-volatile portions) of a solution of dehydroabietic acid (molecular weight: 300.44, functional group equivalent weight of the acid site: 300 g/eq., manufactured by Wako Pure Chemical Industries, Ltd.) in MEK (non-volatile portions 50% by mass); as the inorganic filler (E), 153.8 parts by mass (100 parts by mass in terms of non-volatile portions) of a slurry silica (average particle diameter: 0.3 µm, non-volatile portions 65% by mass, SC1050-MLQ manufactured by Admatechs Company Limited., vinylsilane-treated); as the silane coupling agent, 2 parts by mass of phenylaminosilane (KBM-573 manufactured by Shin-Etsu Chemical Co., Ltd.); and as the radical polymerization initiator, 0.5 parts by mass of dicumyl peroxide (10 hour half-life period temperature: 116.4°C, manufactured by Kishida Chemical Co., Ltd.) were mixed and stirred for 30 minutes by using a high speed stirring apparatus, thereby obtaining a varnish. With this varnish, a polyethylene terephthalate film having a thickness of 38 µm (TR1-38, manufactured by UNITIKA LTD.), the surface of which was coated with a mold releasing agent, was coated and it was heated and dried at 100°C for 5 minutes, thereby obtaining a resin laminate with the resin composition layer of the present embodiment having a thickness of 30 µm.

### (Example 6)

A varnish was prepared in the same manner as in Example 5 except that the organic compound (B) having the flux function was changed to a maleic acid-modified rosin resin (MALKYD (registered trademark) No. 32 manufactured by Arakawa Chemical Industries, Ltd.) instead of dehydroabietic acid, thereby obtaining a resin laminate.

### (Example 7)

A varnish was prepared in the same manner as in Example 5 except that the organic compound (B) having the flux function was changed to N,N'-bis(salicylidene)-1,2-propanediamine (pKa: 12 to 13, manufactured by Tokyo Kasei Kogyo Co., Ltd.) instead of dehydroabietic acid, thereby obtaining a resin laminate.

### (Example 8)

A varnish was prepared in the same manner as in Example 5 except that the organic compound (B) having the flux function was changed to N,N'-bis(salicylidene)-1,3-propanediamine (pKa: 12 to 13, manufactured by Tokyo Kasei Kogyo Co., Ltd.) instead of dehydroabietic acid, thereby obtaining a resin laminate.

### (Example 9)

A varnish was prepared in the same manner as in Example 6 except that the inorganic filler (E) was changed to a slurry silica (0.3 µm SV-EM1 manufactured by Admatechs Company Limited., average particle diameter 0.3 µm, low alpha beam grade, vinylsilane-treated) instead of the slurry silica (SC1050-MLQ manufactured by Admatechs Company Limited.), that phenylaminosilane (KBM-573 manufactured by Shin-Etsu Chemical Co., Ltd.) was not compounded as the silane coupling agent, and that 1 part by mass of DISPERBYK (registered trademark)-111 (manufactured by BYK Japan KK.) was mixed in as the wetting and dispersing agent, thereby obtaining a resin laminate.

### (Example 10)

A varnish was prepared in the same manner as in Example 9 except that the inorganic filler (E) was changed to a slurry silica (0.3 µm SX-EM1 manufactured by Admatechs Company Limited., average particle diameter 0.3 µm, low alpha beam grade, phenylaminosilane-treated) instead of the slurry silica (0.3 µm SV-EM1 manufactured by Admatechs Company Limited., average particle diameter 0.3 µm, low alpha beam grade, vinylsilane-treated), thereby obtaining a resin laminate.

### (Example 11)

A varnish was prepared in the same manner as in Example 10 except that the amount of the benzoxazine compound of the above general formula (5-1) as the benzoxazine compound (A) was changed from 25 parts by mass to 40 parts by mass in terms of non-volatile portions, and that the amount of the maleimide compound of the above formula (8), the amount of bis-(3-ethyl-5-methyl-4-maleimidophenyl)methane (BMI-70, manufactured by K·I Chemical Industry Co., LTD.), and the amount of 2,2-bis(4-(4-maleimidophenoxy)phenyl)propane (BMI-80, manufactured by K·I Chemical Industry Co., LTD.) as the thermosetting components (C) were changed from 8 parts by mass to 5 parts by mass in terms of non-volatile portions, from 16 parts by mass to 10 parts by mass in terms of non-volatile portions, and from 16 parts by mass to 10 parts by mass in terms of non-volatile portions, respectively, thereby obtaining a resin laminate.

### (Example 12)

A varnish was prepared in the same manner as in Example 6 except that the benzoxazine compound (A) was changed to a benzoxazine compound of the above general formula (6-1) (an F-a-based benzoxazine manufactured by SHIKOKU CHEMICALS CORPORATION) instead of the benzoxazine compound of the above general formula (5-1), that the organic compound (B) having the flux function was changed to dehydroabietic acid (molecular weight: 300.44, pKa: 4 to 5, functional group equivalent weight of the acid site: 300 g/eq., manufactured by Wako Pure Chemical Industries, Ltd.) instead of the maleic acid-modified rosin resin (MALKYD (registered trademark) No. 32 manufactured by Arakawa Chemical Industries, Ltd.), that the inorganic filler (E) was changed to the slurry silica (average particle diameter: 0.3 µm, non-volatile portions 65% by mass, 0.3 µm SX-CM1 manufactured by Admatechs Company Limited., phenylaminosilane-treated) instead of the slurry silica (average particle diameter: 0.3 µm, non-volatile portions 65% by mass, SC1050-MLQ manufactured by Admatechs Company Limited., vinylsilane-treated), and that 2 parts by mass of phenylaminosilane (KBM-573 manufactured by Shin-Etsu Chemical Co., Ltd.) was not compounded as the silane coupling agent, thereby obtaining a resin laminate.

### (Example 13)

A varnish was prepared in the same manner as in Example 12 except that the amount of the benzoxazine compound of the above general formula (6-1) was changed from 25 parts by mass to 50 parts by mass in terms of non-volatile portions, and that the amount of the maleimide compound of the above formula (8), the amount of bis-(3-ethyl-5-methyl-4-maleimidophenyl)methane (BMI-70, manufactured by K·I Chemical Industry Co., LTD.), and the amount of 2,2-bis(4-(4-maleimidophenoxy)phenyl)propane (BMI-80, manufactured by K·I Chemical Industry Co., LTD.) as the thermosetting components (C) were changed from 8 parts by mass to 3 parts by mass in terms of non-volatile portions, from 16 parts by mass to 6 parts by mass in terms of non-volatile portions, and from 16 parts by mass to 6 parts by mass in terms of non-volatile portions, respectively, thereby obtaining a resin laminate.

### (Comparative Example 1)

As the thermosetting components, 26 parts by mass (13 parts by mass in terms of non-volatile portions) of a solution of a maleimide compound wherein all R¹¹ in the above formula (8) is a hydrogen atom and n⁴ is 1 to 3 (BMI-2300, manufactured by Daiwa kasei Industry Co., LTD.) in MEK (non-volatile portions 50% by mass), 52 parts by mass (26 parts by mass in terms of non-volatile portions) of a solution of bis-(3-ethyl-5-methyl-4-maleimidophenyl)methane (BMI-70, manufactured by K·I Chemical Industry Co., LTD.) in MEK (non-volatile portions 50% by mass), 52 parts by mass (26 parts by mass in terms of non-volatile portions) of a solution of 2,2-bis(4-(4-maleimidophenoxy)phenyl)propane (BMI-80, manufactured by K·I Chemical Industry Co., LTD.) in MEK (non-volatile portions 50% by mass), and 50 parts by mass (25 parts by mass in terms of non-volatile portions) of a solution of a maleimide compound represented by the above formula (9) (n⁵ in the above formula (9) is 14 (average value), BMI-1000P, manufactured by K·I Chemical Industry Co., LTD.) in MEK (non-volatile portions 50% by mass); as the flexibility imparting component, 10 parts by mass of an acrylic polymer (ARUFON (registered trademark) US-6170 manufactured by Toagosei Co., Ltd.); as the organic compound having the flux function, 40 parts by mass (20 parts by mass in terms of non-volatile portions) of a solution of dehydroabietic acid (molecular weight: 300.44, functional group equivalent weight of the acid site: 300 g/eq., manufactured by Wako Pure Chemical Industries, Ltd.) in MEK (non-volatile portions 50% by mass); as the inorganic filler (E), 153.8 parts by mass (100 parts by mass in terms of non-volatile portions) of a slurry silica (average particle diameter: 0.3 µm, non-volatile portions 65% by mass, SC1050-MLQ manufactured by Admatechs Company Limited., vinylsilane-treated); and as the curing accelerator, 1 part by mass (0.1 parts by mass in terms of non-volatile portions) of a solution of 2-ethyl-4-methylimidazole (2E4MZ, manufactured by SHIKOKU CHEMICALS CORPORATION) in MEK (non-volatile portions 10% by mass) were mixed and stirred for 30 minutes by using a high speed stirring apparatus, thereby obtaining a varnish. With this varnish, a polyethylene terephthalate film having a thickness of 38 µm (TR1-38, manufactured by UNITIKA LTD.), the surface of which was coated with a mold releasing agent, was coated, and it was then heated and dried at 100°C for 5 minutes, thereby obtaining a resin laminate with the resin composition layer of the present embodiment having a thickness of 30 µm.

### (Comparative Example 2)

Furthermore, a varnish was prepared in the same manner as in Comparative Example 1 except that 5 parts by mass of phenylaminosilane (KBM-573 manufactured by Shin-Etsu Chemical Co., Ltd.) was mixed in as the silane coupling agent and that 0.05 parts by mass of a silicone-based surface conditioner (BYK-310 manufactured by BYK Japan KK.) was mixed in as the leveling agent, thereby obtaining a resin laminate.

### (Comparative Example 3)

Furthermore, a varnish was prepared in the same manner as in Comparative Example 1 except that 3 parts by mass of phenylaminosilane (KBM-573 manufactured by Shin-Etsu Chemical Co., Ltd.) was mixed in as the silane coupling agent, that 0.5 parts by mass of dicumyl peroxide (10 hour half-life period temperature: 116.4°C, manufactured by Kishida Chemical Co., Ltd.) was mixed in as the radical polymerization initiator, and that 0.1 parts by mass of 2-ethyl-4-methylimidazole was not compounded as the curing accelerator, thereby obtaining a resin laminate.

### (Comparative Example 4)

A varnish was prepared in the same manner as in Comparative Example 3 except that the organic compound having the flux function was changed to a maleic acid-modified rosin resin (MALKYD (registered trademark) No. 32 manufactured by Arakawa Chemical Industries, Ltd.) instead of dehydroabietic acid, thereby obtaining a resin laminate.

### (Comparative Example 5)

As the thermosetting components, 24 parts by mass (12 parts by mass in terms of non-volatile portions) of a solution of a maleimide compound wherein all R¹¹ in the above formula (8) is a hydrogen atom and n⁴ is 1 to 3 (BMI-2300, manufactured by Daiwa kasei Industry Co., LTD.) in MEK (non-volatile portions 50% by mass), 48 parts by mass (24 parts by mass in terms of non-volatile portions) of a solution of bis-(3-ethyl-5-methyl-4-maleimidophenyl)methane (BMI-70, manufactured by K·I Chemical Industry Co., LTD.) in MEK (non-volatile portions 50% by mass), and 48 parts by mass (24 parts by mass in terms of non-volatile portions) of a solution of 2,2-bis(4-(4-maleimidophenoxy)phenyl)propane (BMI-80, manufactured by K·I Chemical Industry Co., LTD.) in MEK (non-volatile portions 50% by mass); as the flexibility imparting components, 150 parts by mass (30 parts by mass in terms of non-volatile portions) of an acrylic polymer (Mw: 700,000, non-volatile portions 20% by mass, TEISANRESIN (registered trademark) SG-708-6 manufactured by Nagase ChemteX Corporation) and 10 parts by mass of an acrylic polymer (ARUFON (registered trademark) US-6170 manufactured by Toagosei Co., Ltd.); as the organic compound having the flux function, 40 parts by mass (20 parts by mass in terms of non-volatile portions) of a solution of 2-(p-toluoyl)benzoic acid (manufactured by Tokyo Kasei Kogyo Co., Ltd.) in MEK (non-volatile portions 50% by mass); as the inorganic filler (E), 153.8 parts by mass (100 parts by mass in terms of non-volatile portions) of a slurry silica (average particle diameter: 0.3 µm, non-volatile portions 65% by mass, SC1050-MLQ manufactured by Admatechs Company Limited., vinylsilane-treated); as the silane coupling agent, 3 parts by mass of phenylaminosilane (KBM-573 manufactured by Shin-Etsu Chemical Co., Ltd.); and as the radical polymerization initiator, 0.5 parts by mass of dicumyl peroxide (10 hour half-life period temperature: 116.4°C, manufactured by Kishida Chemical Co., Ltd.) were mixed and stirred for 30 minutes by using a high speed stirring apparatus, thereby obtaining a varnish. With this varnish, a polyethylene terephthalate film having a thickness of 38 µm (TR1-38, manufactured by UNITIKA LTD.), the surface of which was coated with a mold releasing agent, was coated and it was then heated and dried at 100°C for 5 minutes, thereby obtaining a resin laminate with the resin composition layer of the present embodiment having a thickness of 30 µm.

### (Comparative Example 6)

As the benzoxazine compound (A), 180 parts by mass (90 parts by mass in terms of non-volatile portions) of a solution of a benzoxazine compound of the above general formula (5-1) (a P-d-based benzoxazine manufactured by SHIKOKU CHEMICALS CORPORATION) in MEK (non-volatile portions 50% by mass); as the organic compound (B) having the flux function, 40 parts by mass (20 parts by mass in terms of non-volatile portions) of a solution of dehydroabietic acid (molecular weight: 300.44, pKa: 4 to 5, functional group equivalent weight of the acid site: 300 g/eq., manufactured by Wako Pure Chemical Industries, Ltd.) in MEK (non-volatile portions 50% by mass); as the thermosetting component (C), 10 parts by mass (5 parts by mass in terms of non-volatile portions) of a solution of a maleimide compound represented by the above formula (9) (n⁵ in the above formula (9) is 14 (average value), BMI-1000P, manufactured by K·I Chemical Industry Co., LTD.) in MEK (non-volatile portions 50% by mass); as the inorganic filler (E), 153.8 parts by mass (100 parts by mass in terms of non-volatile portions) of a slurry silica (0.3 µm SX-EM1 manufactured by Admatechs Company Limited., average particle diameter 0.3 µm, low alpha beam grade, phenylaminosilane-treated); as the flexibility imparting component (F), 5 parts by mass of an acrylic polymer (ARUFON (registered trademark) US-6170 manufactured by Toagosei Co., Ltd.); as the radical polymerization initiator, 0.5 parts by mass of dicumyl peroxide (10 hour half-life period temperature: 116.4°C, manufactured by Kishida Chemical Co., Ltd.); and as the wetting and dispersing agent, 1 part by mass of DISPERBYK (registered trademark)-111 (manufactured by BYK Japan KK.) were mixed and stirred for 30 minutes by using a high speed stirring apparatus, thereby obtaining a varnish. With this varnish, a polyethylene terephthalate film having a thickness of 38 µm (TR1-38, manufactured by UNITIKA LTD.), the surface of which was coated with a mold releasing agent, was coated, and the film was heated and dried at 100°C for 5 minutes, thereby obtaining a resin laminate with the resin composition layer of the present embodiment having a thickness of 30 µm.

### (Comparative Example 7)

As the benzoxazine compound (A), 30 parts by mass (15 parts by mass in terms of non-volatile portions) of a solution of a benzoxazine compound of the above general formula (5-1) (a P-d-based benzoxazine manufactured by SHIKOKU CHEMICALS CORPORATION) in MEK (non-volatile portions 50% by mass); as the organic compound (B) having the flux function, 40 parts by mass (20 parts by mass in terms of non-volatile portions) of a solution of dehydroabietic acid (molecular weight: 300.44, pKa: 4 to 5, functional group equivalent weight of the acid site: 300 g/eq., manufactured by Wako Pure Chemical Industries, Ltd.) in MEK (non-volatile portions 50% by mass); as the thermosetting components (C), 60 parts by mass (30 parts by mass in terms of non-volatile portions) of a solution of a maleimide compound wherein all R¹¹ in the above formula (8) is a hydrogen atom and n⁴ is 1 to 3 (BMI-2300, manufactured by Daiwa kasei Industry Co., LTD.) in MEK (non-volatile portions 50% by mass) and 90 parts by mass (45 parts by mass in terms of non-volatile portions) of a solution of a maleimide compound represented by the above formula (9) (n⁵ in the above formula (9) is 14 (average value), BMI-1000P, manufactured by K·I Chemical Industry Co., LTD.) in MEK (non-volatile portions 50% by mass); as the inorganic filler (E), 153.8 parts by mass (100 parts by mass in terms of non-volatile portions) of a slurry silica (0.3 µm SX-EM1 manufactured by Admatechs Company Limited., average particle diameter 0.3 µm, low alpha beam grade, phenylaminosilane-treated); as the flexibility imparting component (F), 10 parts by mass of an acrylic polymer (ARUFON (registered trademark) US-6170 manufactured by Toagosei Co., Ltd.); as the radical polymerization initiator, 0.5 parts by mass of dicumyl peroxide (10 hour half-life period temperature: 116.4°C, manufactured by Kishida Chemical Co., Ltd.); and as the wetting and dispersing agent, 1 part by mass of DISPERBYK (registered trademark)-111 (manufactured by BYK Japan KK.) were mixed and stirred for 30 minutes by using a high speed stirring apparatus, thereby obtaining a varnish. With this varnish, a polyethylene terephthalate film having a thickness of 38 µm (TR1-38, manufactured by UNITIKA LTD.), the surface of which was coated with a mold releasing agent, was coated and the film was heated and dried at 100°C for 5 minutes, thereby obtaining a resin laminate with the resin composition layer of the present embodiment having a thickness of 30 µm.

### (Comparative Example 8)

As the thermosetting components, 124 parts by mass (62 parts by mass in terms of non-volatile portions) of a solution of a bisphenol A-based epoxy compound (EXA-850CRP manufactured by DIC CORPORATION) in MEK (non-volatile portions 50% by mass) and 76 parts by mass (38 parts by mass in terms of non-volatile portions) of a solution of a novolac-based phenol compound (PHENOLITE (registered trademark) KA-1163 manufactured by DIC CORPORATION) in MEK (non-volatile portions 50% by mass); and as the organic compound having the flux function, 40 parts by mass (20 parts by mass in terms of non-volatile portions) of a solution of dehydroabietic acid (molecular weight: 300.44, functional group equivalent weight of the acid site: 300 g/eq., manufactured by Wako Pure Chemical Industries, Ltd.) in MEK (non-volatile portions 50% by mass) were mixed and stirred for 30 minutes by using a high speed stirring apparatus, thereby obtaining a varnish. With this varnish, a polyethylene terephthalate film having a thickness of 38 µm (TR1-38, manufactured by UNITIKA LTD.), the surface of which was coated with a mold releasing agent, was coated, and the film was then heated and dried at 100°C for 5 minutes, thereby obtaining a resin laminate with the resin composition layer of the present embodiment having a thickness of 30 µm.

### (Comparative Example 9)

As the thermosetting components, 45 parts by mass (22.5 parts by mass in terms of non-volatile portions) of a solution of a cresol novolac-based epoxy compound (EOCN-1020-70 manufactured by Nippon Kayaku Co., Ltd.) in MEK (non-volatile portions 50% by mass) and 20 parts by mass (10 parts by mass in terms of non-volatile portions) of a solution of a novolac-based phenol compound (PS-4271 manufactured by Gunei Chemical Industry Co., Ltd.) in MEK (non-volatile portions 50% by mass); as the organic compound having the flux function, 20 parts by mass (10 parts by mass in terms of non-volatile portions) of a solution of phenolphthalin (molecular weight: 320.34, functional group equivalent weight of the acid site: 320.34 g/eq., manufactured by Wako Pure Chemical Industries, Ltd.) in MEK (non-volatile portions 50% by mass); as the flexibility imparting component (F), 450 parts by mass (67.5 parts by mass in terms of non-volatile portions) of a solution of an acrylic polymer (Mw: 850,000, non-volatile portions 15% by mass, TEISANRESIN (registered trademark) SG-P3 manufactured by Nagase ChemteX Corporation)in MEK; 137.5 parts by mass of silica (average particle diameter: 2.2 µm, SC6103-SQ manufactured by Admatechs Company Limited., SQ-treated); as the silane coupling agent, 1.25 parts by mass of 2-(3,4-epoxycyclohexyl)ethyltrimethoxysilane (KBM-303 manufactured by Shin-Etsu Chemical Co., Ltd.); and as the curing accelerator, 12.5 part by mass (1.25 parts by mass in terms of non-volatile portions) of a solution of 2-phenyl-4-methylimidazole (2P4MZ, manufactured by SHIKOKU CHEMICALS CORPORATION) in MEK (non-volatile portions 10% by mass) were mixed and stirred for 30 minutes by using a high speed stirring apparatus, thereby obtaining a varnish. With this varnish, a polyethylene terephthalate film having a thickness of 38 µm (TR1-38, manufactured by UNITIKA LTD.), the surface of which was coated with a mold releasing agent, was coated and the film was then heated and dried at 100°C for 5 minutes, thereby obtaining a resin laminate with the resin composition layer of the present embodiment having a thickness of 30 µm.

### [2. Evaluation of resin composition]

### (1) Flux activity

The resin laminates obtained in Examples 1 to 13 and Comparative Examples 1 to 9 were cut into 8 mm x 8 mm, which were stuck to the pad portion (15 µm Cu) of a substrate for mounting a semiconductor, WALTS-KIT MB50-0102JY manufactured by WALTS CO., LTD. so as to cover it, thereby obtaining a substrate for mounting a semiconductor with a resin laminate. Next, using a flip chip bonder, the bump portion (30 µm Cu pillar + 15 µm SnAg solder) of a semiconductor chip WALTS-TEG MB50-0101JY manufactured by WALTS CO., LTD. and the pad portion of the substrate for mounting the semiconductor with the resin laminate were aligned to be overlapped accurately, and then melted and joined with solder, thereby obtaining a semiconductor device. After subjecting the obtained semiconductor device to a heat treatment in an oven at 200°C for 2 hours, cross section polishing observation of the joint portion was performed to confirm the solder joint state. As a result of the cross section observation, when sufficient solder wettability was confirmed, it was described as A, and when no solder wettability was confirmed, it was described as C. The results are shown in Tables 1 and 2.

### (2) Chip adhesiveness

Evaluation of chip adhesiveness was performed in accordance with JIS K5600-5-6. For example, the resin laminates obtained in Examples 1 to 13 and Comparative Examples 1 to 7 were divided into individual chips with 4 cm x 4 cm, which were then stuck with a vacuum pressing laminator, thereby obtaining chips with a resin composition layer. These chips with a resin composition layer were heated at 200°C for 3 hours using an oven. After returning the temperature to room temperature, to the chips with a resin composition layer, six incisions for each of the vertical and horizontal direction were provided at 1 mm intervals so as to be orthogonal to each other, thereby forming a 25-grid rectangular pattern. After subjecting the chips with a resin composition layer and incisions to a pressurization and moisture absorption treatment using a pressure cooker (temperature: 121°C, humidity: 100% RH, pressure: 2 atm) for up to 96 hours, a peeling test with a transparency sticking tape was performed under a room temperature environment.

As a result of the peeling test, the case where no peeling was confirmed at all was described as A, the case where peeling was confirmed only in a very small portion was described as B, and the case where large peeling was confirmed was described as C. The results are shown in Table 1 and Table 2.

### (3) HAST

The resin laminates obtained in Examples 1 to 13 and Comparative Examples 1 to 7 were each stuck onto a fine circuit pattern with L/S = 40/40 µm of a printed wiring substrate by a vacuum laminator to fill the gaps between the fine wirings. Using an oven, the fine circuit pattern substrate with the resin laminate fabricated as described above was heated at 200°C for 3 hours, thereby fabricating a test sample. As a pretreatment, the obtained test sample was subjected to a humidification heat treatment under conditions with a temperature of 85°C and a humidity of 60% for 168 hours, and the treated sample was allowed to pass through a reflow step in which the maximum temperature was set to 260°C three times. For the test sample after the pretreatment, the continuous humidity insulation resistance was measured under conditions with a temperature of 130°C, a humidity of 85%, and an applied voltage of 5.0 V.

As the evaluation criteria, a resistance value of 10⁷ Ω or less is defined as a short circuit. When it takes 300 hours or longer until being short circuited, it was described as A, and when it takes 100 hours or shorter, it was described as C. The results are shown in Table 1 and Table 2.

**[Table 1]**

| Evaluation | Details | Example 1 | Example 2 | Example 3 | Example 4 | Example 5 | Example 6 | Example 7 | Example 8 | Example 9 | Example 10 | Example 11 | Example 12 | Example 13 |
|---|---|---|---|---|---|---|---|---|---|---|---|---|---|---|
| Flux activity | | A | A | A | A | A | A | A | A | A | A | A | A | A |
| Chip adhesiveness | Cross cut test | A | A | A | A | A | A | A | A | B | A | A | A | A |
| HAST | 10⁷ Ω or more after 300 hrs at 130°C, 85% RH, and 5.0 V | A | A | A | A | A | A | A | A | A | A | A | A | A |

**[Table 2]**

| Evaluation | Details | Comparative Example 1 | Comparative Example 2 | Comparative Example 3 | Comparative Example 4 | Comparative Example 5 | Comparative Example 6 | Comparative Example 7 | Comparative Example 8 | Comparative Example 9 |
|---|---|---|---|---|---|---|---|---|---|---|
| Flux activity | | A | A | A | A | A | C | A | C | C |
| Chip adhesiveness | Cross cut test | C | A | A | A | B | A | A | - | - |
| HAST | 10⁷ Ω or more after 300 hrs at 130°C, 85% RH, and 5.0 V | C | C | C | C | C | A | C | - | - |

The present application is based on Japanese Patent Application No. 2018-85680 filed on April 26, 2018, the contents of which are incorporated herein by reference.

### Industrial Applicability

The resin composition of the present embodiment is excellent in chip adhesiveness, adhesiveness to substrates, and flux activity, and exhibits a variety of effects. Therefore, it is useful as an underfill material, and suitably as a pre-applied underfill material. In particular, since the resin composition of the present embodiment is excellent in flux activity and is also excellent in adhesiveness to a chip and substrates, even when it is used for a laminate obtained through the joint between a chip and a substrate, the joint between a chip and a semiconductor wafer, or even the joint between a chip and a chip, the obtained laminate can be endowed with high reliability that can withstand long term use in the environment in which it is used, which is extremely useful.

## Claims

1. A resin composition comprising:
a benzoxazine compound (A);
an organic compound (B) having a flux function; and
at least one thermosetting component (C) selected from a phenolic resin and a radical polymerizable thermosetting resin,
wherein the radical polymerizable thermosetting resin is a resin or a compound having at least one or more functional groups selected from the group consisting of an alkenyl group, a maleimide group and a (meth)acryloyl group, and
wherein a mass ratio between the benzoxazine compound (A) and the thermosetting component (C) ((A)/(C)) is 20/80 to 90/10.

2. The resin composition according to claim 1, wherein the benzoxazine compound (A) has a molecular weight of 400 or more.

3. The resin composition according to claim 1 or 2, wherein the benzoxazine compound (A) comprises at least one selected from the group consisting of compounds represented by the following formula (1), the following formula (2), the following formula (3), and the following formula (4): 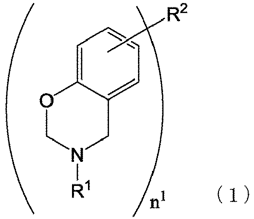 wherein each R¹ independently represents an aryl group, an aralkyl group, an alkenyl group, an alkyl group, or a cycloalkyl group; each R² independently represents a hydrogen atom, an aryl group, an aralkyl group, an alkenyl group, an alkyl group, a cycloalkyl group, or a monovalent to tetravalent organic group represented by the following general formulas (a) to (t); and n¹ represents an integer of 1 to 4; 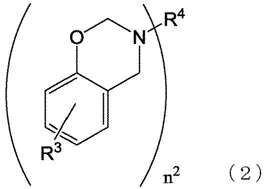 wherein each R³ independently represents a hydrogen atom, an aryl group, an aralkyl group, an alkenyl group, an alkyl group, or a cycloalkyl group; each R⁴ independently represents an aryl group, an aralkyl group, an alkenyl group, an alkyl group, a cycloalkyl group, or a monovalent to tetravalent organic group represented by the following general formulas (a) to (o); and n² represents an integer of 1 to 4; 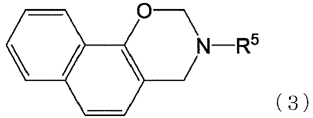 wherein each R⁵ independently represents an alkyl group, a cycloalkyl group, or a phenyl group optionally having a substituent; 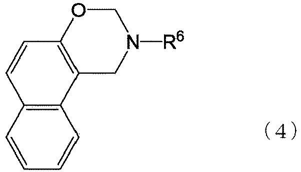 wherein each R⁶ independently represents an alkyl group, a cycloalkyl group, or a phenyl group optionally having a substituent; and 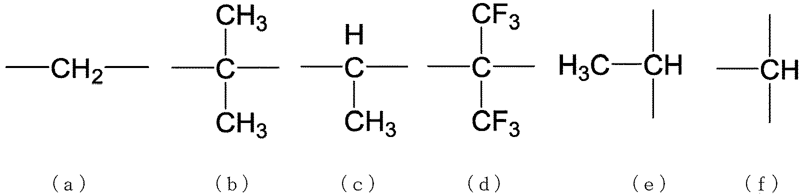 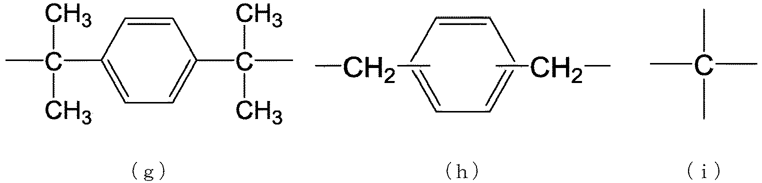 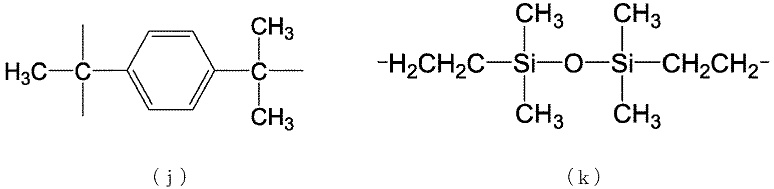 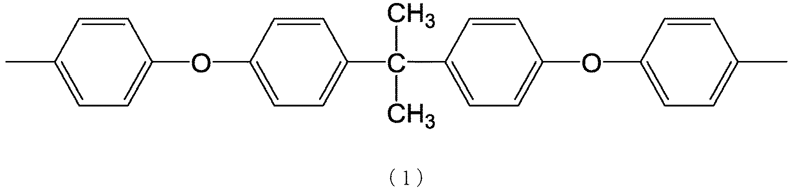 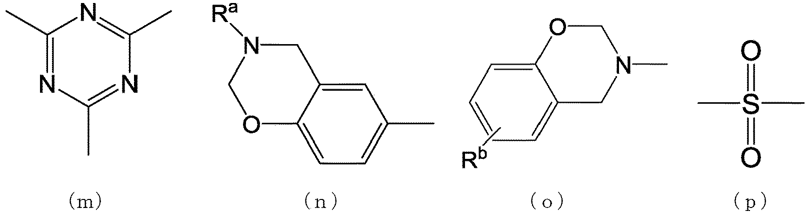 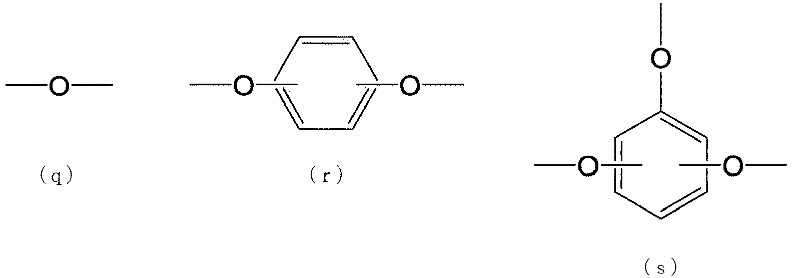 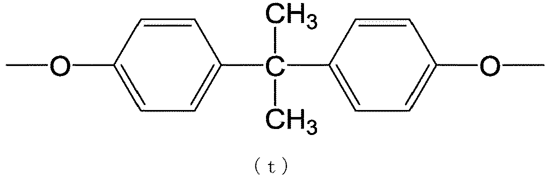 wherein each R^{a} independently represents an aryl group, an aralkyl group, an alkenyl group, an alkyl group, or a cycloalkyl group; each R^{b} independently represents a hydrogen atom, an aryl group, an aralkyl group, an alkenyl group, an alkyl group, or a cycloalkyl group.

4. The resin composition according to any one of claims 1 to 3, wherein the benzoxazine compound (A) comprises at least one selected from the group consisting of compounds represented by the following formula (5) and the following formula (6): 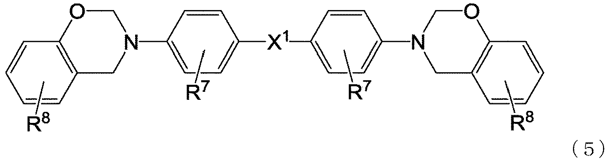 wherein each R⁷ independently represents a hydrogen atom, an aryl group, an aralkyl group, an alkenyl group, an alkyl group, or a cycloalkyl group; each R⁸ independently represents a hydrogen atom, an aryl group, an aralkyl group, an alkenyl group, an alkyl group, or a cycloalkyl group; and X¹ represents an alkylene group, a group represented by the following formula (7), a group represented by the formula "-SO₂-", a group represented by the formula "-CO-", an oxygen atom, or a single bond; 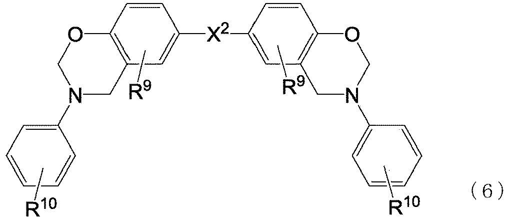 wherein each R⁹ independently represents a hydrogen atom, an aryl group, an aralkyl group, an alkenyl group, an alkyl group, or a cycloalkyl group; each R¹⁰ independently represents a hydrogen atom, an aryl group, an aralkyl group, an alkenyl group, an alkyl group, or a cycloalkyl group; and X² represents an alkylene group, a group represented by the following formula (7), a group represented by the formula "-SO₂-", a group represented by the formula "-CO-", an oxygen atom, or a single bond; and 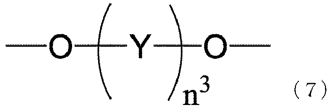 wherein Y is an alkylene group or a hydrocarbon group having 6 or more and 30 or less carbon atoms and having an aromatic ring; and n³ represents an integer of 0 or more and 5 or less.

5. The resin composition according to any one of claims 1 to 4, wherein the benzoxazine compound (A) comprises at least one selected from the group consisting of a compound represented by the following formula (5-1), a compound represented by the following formula (5-2), a compound represented by the following formula (5-3), a compound represented by the following formula (6-1), a compound represented by the following formula (6-2), and a compound represented by the following formula (6-3): 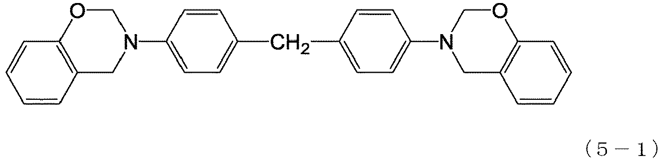 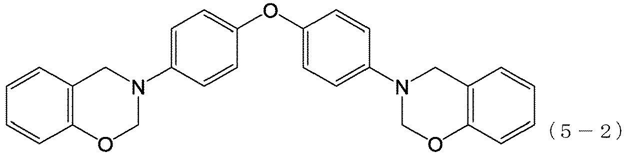 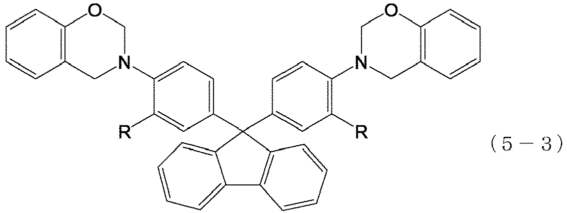 wherein each R independently represents a hydrogen atom or a hydrocarbon group having 1 to 4 carbon atoms;

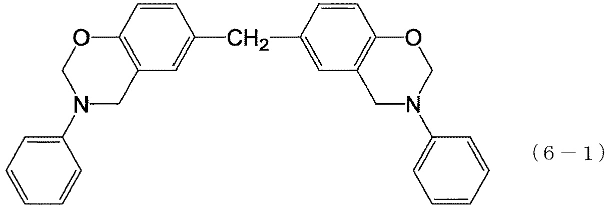

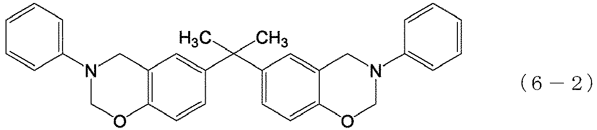

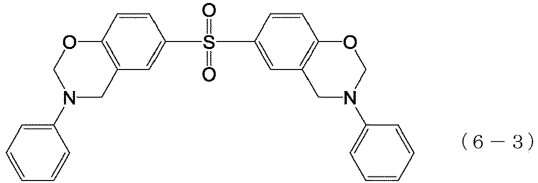

6. The resin composition according to any one of claims 1 to 5, wherein the organic compound (B) having the flux function has an acid dissociation constant pKa of 3.8 or more and 15.0 or less.

7. The resin composition according to any one of claims 1 to 6, wherein the organic compound (B) having the flux function has a molecular weight of 200 or more and 8,000 or less.

8. The resin composition according to any one of claims 1 to 7, wherein the organic compound (B) having the flux function comprises at least one selected from the group consisting of abietic acid, neoabietic acid, dehydroabietic acid, pimaric acid, isopimaric acid, palustric acid, diphenolic acid, dihydroabietic acid, tetrahydroabietic acid, an acid-modified rosin resin, N,N'-bis(salicylidene)-1,2-propanediamine, N,N'-bis(salicylidene)-1,3-propanediamine, and phenolphthalin.

9. The resin composition according to any one of claims 1 to 8, wherein the thermosetting component (C) is a maleimide compound.

10. The resin composition according to any one of claims 1 to 9, wherein the thermosetting component (C) comprises at least one selected from the group consisting of 2,2-bis(4-(4-maleimidophenoxy)phenyl)propane, a maleimide compound represented by the following formula (8), a maleimide compound represented by the following formula (9), a maleimide compound represented by the following formula (10), a maleimide compound represented by the following formula (11), a compound represented by the following formula (12), and a compound represented by the following formula (13): 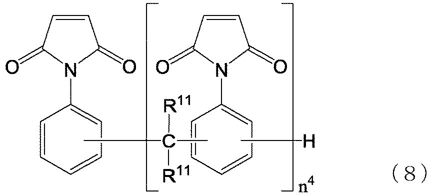 wherein each R¹¹ independently represents a hydrogen atom or a methyl group; and n⁴ represents an integer of 1 or more and 10 or less; 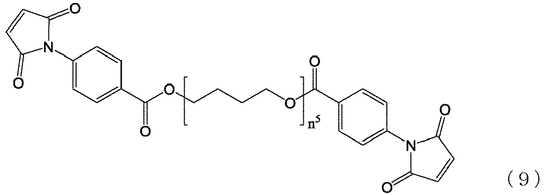 wherein n⁵ represents an integer of 1 or more and 30 or less; 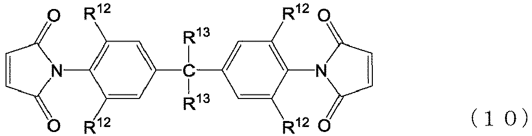 wherein each R¹² independently represents a hydrogen atom, a methyl group, or an ethyl group; and each R¹³ independently represents a hydrogen atom or a methyl group; 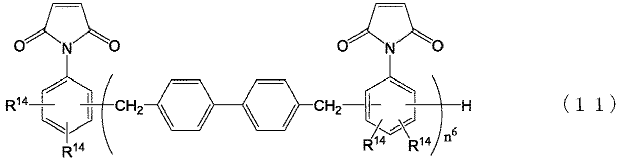 wherein each R¹⁴ independently represents a hydrogen atom, an alkyl group having 1 to 5 carbon atoms, or a phenyl group; and n⁶ represents an integer of 1 or more and 10 or less; 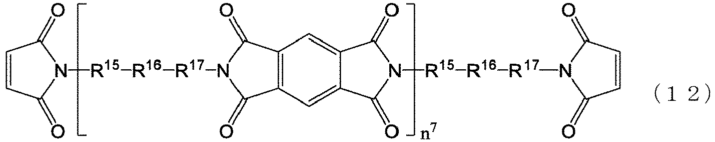 wherein R¹⁵ and R¹⁷ each independently represent a hydrocarbon group in which 8 or more atoms are linearly linked; each R¹⁶ independently represents a substituted or unsubstituted cyclic hydrocarbon group optionally having a heteroatom in which 4 or more and 10 or less atoms constitute the ring; and n⁷ represents a number of 1 or more and 10 or less; 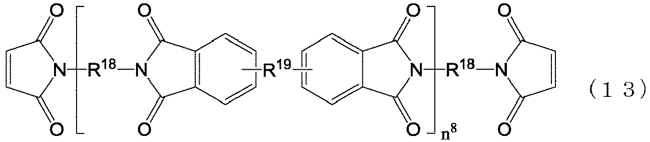 wherein each R¹⁸ independently represents an alkylene group; each R¹⁹ independently represents an alkylene group, a group represented by the following formula (7), a group represented by the formula "-SO₂-", a group represented by the formula "-CO-", a group represented by the following formula (14), an oxygen atom, or a single bond; and n⁸ represents a number of 1 or more and 10 or less; and 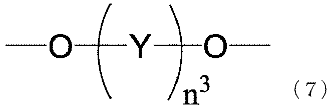 wherein Y is an alkylene group or a hydrocarbon group having 6 or more and 30 or less carbon atoms and having an aromatic ring; and n³ represents an integer of 0 or more and 5 or less.

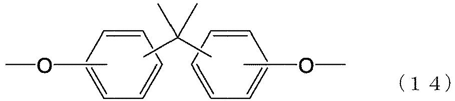

11. The resin composition according to any one of claims 1 to 10, wherein a content of the organic compound (B) having the flux function in the resin composition is 1 part by mass or more and 50 parts by mass or less based on 100 parts by mass in total of the benzoxazine compound (A) and the thermosetting component (C).

12. The resin composition according to any one of claims 1 to 11, further comprising a radical polymerization initiator (D).

13. The resin composition according to claim 12, wherein the radical polymerization initiator (D) has a 10 hour half-life period temperature of 100°C or higher.

14. The resin composition according to claim 12 or 13, wherein the radical polymerization initiator (D) is an organic peroxide.

15. The resin composition according to any one of claims 12 to 14, wherein the radical polymerization initiator (D) has a peroxy ester, a peroxy ketal, a dialkyl peroxide, or a hydroperoxide skeleton.

16. The resin composition according to any one of claims 12 to 15, wherein the radical polymerization initiator (D) comprises at least one selected from the group consisting of dicumyl peroxide, di(2-tert-butylperoxyisopropyl)benzene, 1,1,3,3-tetramethylbutyl hydroperoxide, 2,5-dimethyl-2,5-bis(tert-butylperoxy)hexyne-3, and tert-butyl hydroperoxide.

17. The resin composition according to any one of claims 12 to 16, wherein a content of the radical polymerization initiator (D) in the resin composition is 0.05 parts by mass or more and 10 parts by mass or less based on 100 parts by mass in total of the benzoxazine compound (A) and the thermosetting component (C).

18. The resin composition according to any one of claims 1 to 17, further comprising an inorganic filler (E).

19. The resin composition according to claim 18, wherein the inorganic filler (E) has an average particle diameter of 3 µm or less.

20. The resin composition according to claim 18 or 19, wherein the inorganic filler (E) comprises at least one selected from the group consisting of silica, aluminum hydroxide, alumina, boehmite, boron nitride, aluminum nitride, magnesium oxide, and magnesium hydroxide.

21. The resin composition according to any one of claims 18 to 20, wherein the inorganic filler (E) is silica.

22. The resin composition according to any one of claims 18 to 21, wherein a content of the inorganic filler (E) in the resin composition is 500 parts by mass or less based on 100 parts by mass in total of the benzoxazine compound (A) and the thermosetting component (C).

23. The resin composition according to any one of claims 1 to 22, further comprising a flexibility imparting component (F).

24. The resin composition according to claim 23,
wherein:
the flexibility imparting component (F) comprises a thermoplastic polymer compound; and
the polymer compound has a mass average molecular weight of 1,000 or more and 1,000,000 or less.

25. The resin composition according to claim 23 or 24, wherein the flexibility imparting component (F) is a (meth)acrylic oligomer and/or a (meth)acrylic polymer.

26. The resin composition according to any one of claims 23 to 25, wherein a content of the thermosetting component (C) in the resin composition is 10 parts by mass or more and 70 parts by mass or less based on 100 parts by mass in total of the benzoxazine compound (A), the thermosetting component (C), and the flexibility imparting component (F).

27. The resin composition according to any one of claims 23 to 26, wherein a content of the organic compound (B) having the flux function in the resin composition is 1 part by mass or more and 50 parts by mass or less based on 100 parts by mass in total of the benzoxazine compound (A), the thermosetting component (C), and the flexibility imparting component (F).

28. The resin composition according to any one of claims 23 to 27, wherein a content of the inorganic filler (E) in the resin composition is 500 parts by mass or less based on 100 parts by mass in total of the benzoxazine compound (A), the thermosetting component (C), and the flexibility imparting component (F).

29. The resin composition according to any one of claims 1 to 28, for use in a pre-applied underfill material.

30. A laminate comprising:
a supporting material; and
a layer comprising the resin composition according to any one of claims 1 to 29 laminated on the supporting material.

31. A semiconductor wafer with a resin composition layer, comprising:
a semiconductor wafer; and
the laminate according to claim 30 laminated on the semiconductor wafer,
wherein the layer comprising the resin composition is laminated on the semiconductor wafer.

32. A substrate for mounting a semiconductor with a resin composition layer, comprising:
a substrate for mounting a semiconductor; and
the laminate according to claim 30 laminated on the substrate for mounting the semiconductor,
wherein the layer comprising the resin composition is laminated on the substrate for mounting the semiconductor.

33. A semiconductor device, comprising the semiconductor wafer with the resin composition layer according to claim 31; and/or the substrate for mounting the semiconductor with the resin composition layer according to claim 32.
